(19) **Europäisches Patentamt / European Patent Office / Office européen des brevets**

(11) **EP 4 474 840 A1**

(12) **EUROPEAN PATENT APPLICATION**
published in accordance with Art. 153(4) EPC

(43) Date of publication:
**11.12.2024 Bulletin 2024/50**

(21) Application number: **23749618.7**

(22) Date of filing: **25.01.2023**

(51) International Patent Classification (IPC):
*G01R 31/392* (2019.01)    *G01R 31/379* (2019.01)
*G01R 31/3828* (2019.01)    *H01M 10/48* (2006.01)
*H02J 7/00* (2006.01)

(52) Cooperative Patent Classification (CPC):
**G01R 31/379; G01R 31/3828; G01R 31/392;**
**H01M 10/48; H02J 7/00;** Y02E 60/10

(86) International application number:
**PCT/JP2023/002258**

(87) International publication number:
**WO 2023/149302 (10.08.2023 Gazette 2023/32)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority:  **03.02.2022   JP 2022015642**

(71) Applicants:
• **FURUKAWA ELECTRIC CO., LTD.**
  **Tokyo 100-8322 (JP)**
• **The Furukawa Battery Co., Ltd.**
  **Yokohama-shi, Kanagawa-ken 240-0006 (JP)**

(72) Inventors:
• **KUTSUMA Ayaka**
  **Tokyo 100-8322 (JP)**
• **NAKAMURA Hideto**
  **Tokyo 100-8322 (JP)**
• **TANIMURA Yudai**
  **Tokyo 100-8322 (JP)**
• **SATO Toshiyuki**
  **Yokohama-shi, Kanagawa 240-0006 (JP)**
• **YOSHIDA Hideaki**
  **Nikko-shi, Tochigi 321-2336 (JP)**

(74) Representative: **Grünecker Patent- und**
**Rechtsanwälte**
**PartG mbB**
**Leopoldstraße 4**
**80802 München (DE)**

(54) **LEAD-ACID STORAGE BATTERY SYSTEM, AND LEAD-ACID STORAGE BATTERY LIFE ESTIMATION METHOD**

(57)    Provided are a lead-acid battery system and a lead-acid battery life estimation method capable of accurately estimating a remaining life of a lead-acid battery by calculating a capacity turnover value during operation in consideration of the number of equalization charges of the lead-acid battery or an overcharge rate integrated value of the equalization charge of the lead-acid battery. The lead-acid battery system (S) estimates the remaining life of the lead-acid battery (B) by comparing a capacity turnover value from the beginning to the end of life with the capacity turnover value during operation. A capacity turnover value calculation unit (137) or (237) in the lead-acid battery system (S) calculates the capacity turnover value during operation by using an equalization-charge-number-based correction coefficient $K_{CN}$ calculated based on the number of equalization charges (E) or a charge-rate-based correction coefficient $K_{CP}$ calculated based on the overcharge rate integrated value of the equalization charge (E).

FIG. 4

EP 4 474 840 A1

**Description**

Technical Field

The present invention relates to a lead-acid battery system and a lead-acid battery life estimation method for estimating a remaining life of a lead-acid battery.

Background Art

In recent years, power generation facilities using natural energy such as sunlight and wind power have increased. In such a power generation facility, the amount of power generated cannot be controlled, and thus a storage battery is used to level the power load. That is, when the amount of power generation is larger than the amount of consumption, the difference is charged into storage batteries, and when the amount of power generation is smaller than the amount of consumption, the difference is discharged from the storage batteries.

Examples of such storage batteries include lead-acid batteries and lithium-ion secondary batteries. These storage batteries for power storage are installed in houses, offices, and sites of factories, electric power companies, and the like. The storage batteries are assumed to be used in units of several years to 10 years from the start of operation.

When long-term use is assumed as described above, it is necessary to periodically perform maintenance and management (maintenance) after the start of operation. This is because in a case of various storage batteries as described above, it is known that deterioration progresses with use and available battery capacity decreases. These storage batteries are not replaced immediately when their capacity is depleted after a single discharge unlike primary batteries, but are repeatedly used. Thus, it is required to appropriately grasp the state of installed storage batteries.

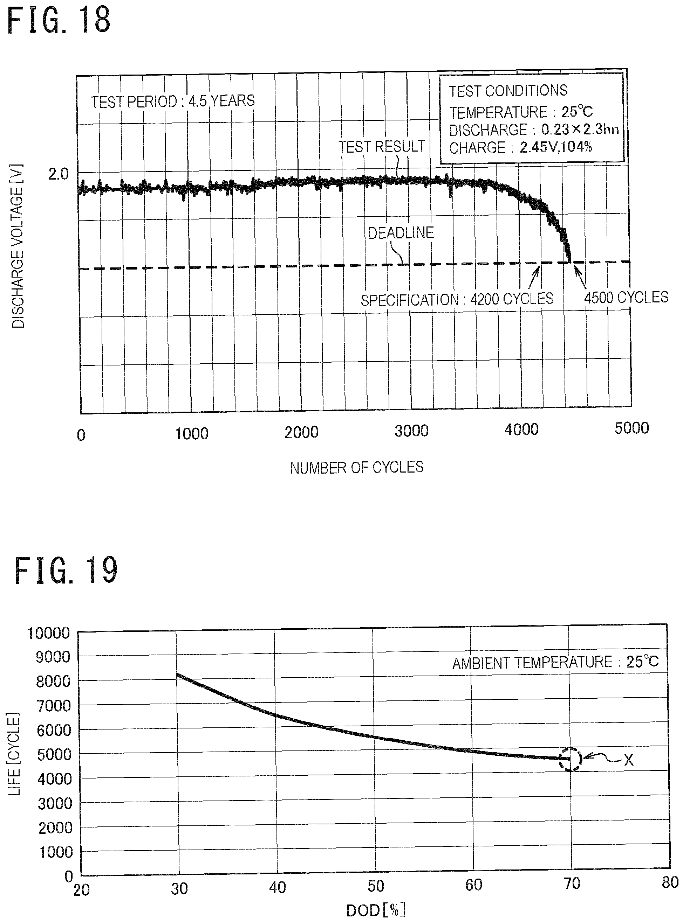

Here, an example of a cycle characteristic of a general lead-acid battery will be described. As illustrated in FIG. 18, a decrease in capacity of the lead-acid battery due to deterioration occurs, for example, from around 3900 cycles with respect to 4500 cycles of life, and there is a possibility that a characteristic change is not observed until the end of the life of the lead-acid battery.

A main factor of the decrease in capacity of the lead-acid battery is a decrease in adhesion between a positive electrode grid and an active material. From the viewpoint of energy density, in a bipolar lead-acid battery that has attracted attention in recent years, there is a possibility that a further rapid decrease in capacity may occur toward the end of life.

In view of the possibility that a characteristic change (capacity decrease) is not observed until the end of the life of the lead-acid battery as described above, it has been hitherto performed to estimate the life of the lead-acid battery from a capacity turnover value (CT value), which is an index related to the number of discharges.

Here, the capacity turnover value is a value obtained by dividing the total discharge capacity by a rated capacity of the storage battery, and is used as a life index of the storage battery. In a cycle charge/discharge lead-acid battery, the number of discharges (cycle life) from the beginning to the end of life is obtained under certain conditions, and the capacity turnover value from the beginning to the end of life can be calculated. FIG. 19 illustrates an example of a relationship between a DOD representing a depth of discharge and the life of the storage battery. In a case where a lead-acid battery having a rated capacity of 1000 Ah as indicated by an arrow X is dischargeable for 4500 cycles with a DOD of 70%, the capacity turnover value from the beginning to the end of life is total discharge capacity (1000 Ah × 70% × 4500 cycles)/rated capacity (1000 Ah) = 3150 (times).

Therefore, the remaining life of the lead-acid battery can be estimated by comparing the capacity turnover value from the beginning to the end of life with the capacity turnover value during operation.

On the other hand, as a conventional lead-acid battery life prediction method, for example, a method described in PTL 1 is known.

The lead-acid battery life prediction method described in PTL 1 integrates a charged electricity amount from a charge current value of a lead-acid battery, and predicts a life of the lead-acid battery from the integrated value. In the lead-acid battery life prediction method described in PTL 1, a relationship between a charging battery voltage and a battery temperature and a charging current is measured in advance using a standard lead-acid battery, a charging battery voltage and a battery temperature of a target lead-acid battery are detected, and a charge current value is determined based on the detected values and the above-described relationship.

Citation List

Patent Literature

PTL 1: JP H2-288074 A

## Summary of Invention

### Technical Problem

However, in the conventional lead-acid battery life prediction method described in PTL 1, in prediction of a life of a lead-acid battery, a charged electricity amount is integrated from a charge current value of the lead-acid battery, and the life of the lead-acid battery is predicted from the integrated value, and a remaining life of the lead-acid battery is not estimated by comparing the above-described capacity turnover value from the beginning to the end of life and the capacity turnover value during operation. Therefore, it is difficult to accurately estimate the remaining life of the lead-acid battery.

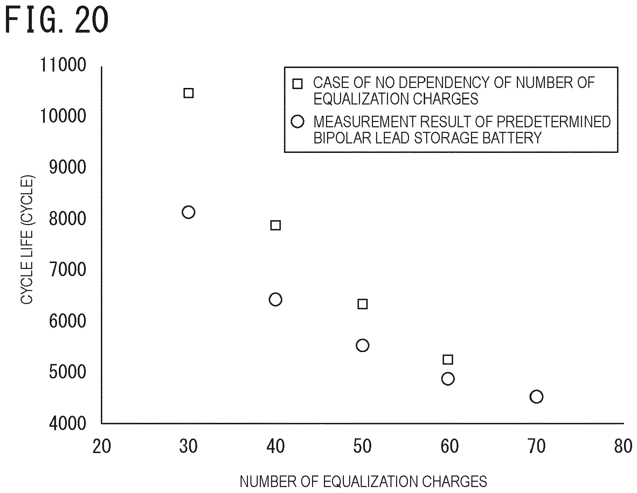

Meanwhile, factors of a decrease in life of a lead-acid battery include an increase in the number of equalization charges of the lead-acid battery and an increase in overcharge rate integrated value of the equalization charge of the lead-acid battery, and when the number of equalization charges increases or the overcharge rate integrated value increases, corrosion of a positive electrode and softening of an active material due to electrolyte loss progress. For this reason, when the capacity turnover value during operation is calculated without considering the number of equalization charges of the lead-acid battery and the overcharge rate integrated value of the equalization charge of the lead-acid battery, there is a problem that the accuracy in estimation of the remaining life of the lead-acid battery decreases. FIG. 20 illustrates an example of a relationship between the number of equalization charges and a cycle life for a predetermined bipolar lead-acid battery, and it can be seen that the cycle life is shortened as the number of equalization charges increases.

Therefore, an object of the present invention is to provide a lead-acid battery system and a lead-acid battery life estimation method capable of accurately estimating a remaining life of a lead-acid battery by calculating a capacity turnover value during operation in consideration of the number of equalization charges of the lead-acid battery or an overcharge rate integrated value of the equalization charge of the lead-acid battery.

### Solution to Problem

A lead-acid battery system according to an aspect of the present invention is a lead-acid battery system configured to estimate a remaining life of a lead-acid battery by comparing a capacity turnover value from a beginning to an end of life with a capacity turnover value during operation, the lead-acid battery system including a capacity turnover value calculation unit configured to calculate the capacity turnover value during operation, in which the capacity turnover value calculation unit calculates the capacity turnover value during operation by using an equalization-charge-number-based correction coefficient calculated based on the number of equalization charges calculated by an equalization charge number calculation unit configured to calculate the number of equalization charges of the lead-acid battery, or a charge-rate-based correction coefficient calculated based on an overcharge rate integrated value of the equalization charge calculated by an overcharge rate integrated value calculation unit configured to calculate the overcharge rate integrated value of the equalization charge of the lead-acid battery.

A lead-acid battery life estimation method according to another aspect of the present invention is a lead-acid battery life estimation method in which a remaining life of a lead-acid battery is estimated by comparing a capacity turnover value from a beginning to an end of life and a capacity turnover value during operation, the lead-acid battery life estimation method including a capacity turnover value calculation step of calculating the capacity turnover value during operation, in which in the capacity turnover value calculation step, the capacity turnover value during operation is calculated using an equalization-charge-number-based correction coefficient calculated based on the number of equalization charges calculated in an equalization charge number calculation step of calculating the number of equalization charges of the lead-acid battery, or a charge-rate-based correction coefficient calculated based on an overcharge rate integrated value of the equalization charge calculated in an overcharge rate integrated value calculation step of calculating the overcharge rate integrated value of the equalization charge of the lead-acid battery.

### Advantageous Effects of Invention

In the lead-acid battery system according to the present invention, the capacity turnover value calculation unit calculates the capacity turnover value during operation by using the equalization-charge-number-based correction coefficient based on the number of equalization charges calculated by the equalization charge number calculation unit configured to calculate the number of equalization charges of the lead-acid battery, or the charge-rate-based correction coefficient calculated based on the overcharge rate integrated value of the equalization charge calculated by the overcharge rate integrated value calculation unit configured to calculate the overcharge rate integrated value of the equalization charge of the lead-acid battery. As a result, by calculating the capacity turnover value during operation in consideration of the number of equalization charges of the lead-acid battery or the overcharge rate integrated value of the equalization charge of the lead-acid battery, it is possible to consider the progress of corrosion of a positive electrode and softening of an active material due to electrolyte loss and to provide the lead-acid battery system capable of accurately estimating the remaining life of the lead-acid battery.

Further, in the lead-acid battery system according to the present invention, in a case where the equalization charge of the lead-acid battery is interrupted in the middle, the equalization charge number calculation unit calculates the number of equalization charges based on a constant voltage (CV) charge time from when a CV charge, which is charging at a constant voltage, starts to when the equalization charge is interrupted and a CV time for equalization charge completion determination, and the capacity turnover value calculation unit calculates the equalization-charge-number-based correction coefficient based on the number of equalization charges calculated by the equalization charge number calculation unit. As a result, in a case where the equalization charge is interrupted in the middle, the accurate number of equalization charges can be calculated, and as a result, the accurate equalization-charge-number-based correction coefficient can be calculated, and the remaining life of the lead-acid battery can be estimated with high accuracy.

In the lead-acid battery system according to the present invention, in a case where the equalization charge of the lead-acid battery is interrupted in the middle, the equalization charge number calculation unit calculates the number of equalization charges based on the charge rate when the equalization charge is interrupted and the charge rate for the equalization charge completion determination, and the capacity turnover value calculation unit calculates the equalization-charge-number-based correction coefficient based on the number of equalization charges calculated by the equalization charge number calculation unit. As a result, in a case where the equalization charge is interrupted in the middle, the accurate number of equalization charges can be calculated, and as a result, the accurate equalization-charge-number-based correction coefficient can be calculated, and the remaining life of the lead-acid battery can be estimated with high accuracy.

In the lead-acid battery system of the present invention, the lead-acid battery is a bipolar lead-acid battery. Accordingly, it is possible to provide the lead-acid battery system capable of accurately estimating the remaining life of the bipolar lead-acid battery.

In addition, in the lead-acid battery life estimation method according to the present invention, in the capacity turnover value calculation step, the capacity turnover value during operation is calculated by using the equalization-charge-number-based correction coefficient based on the number of equalization charges calculated in the equalization charge number calculation step of calculating the number of equalization charges of the lead-acid battery, or the charge-rate-based correction coefficient calculated based on the overcharge rate integrated value of the equalization charge calculated in the overcharge rate integrated value calculation step of calculating the overcharge rate integrated value of the equalization charge of the lead-acid battery. As a result, by calculating the capacity turnover value during operation in consideration of the number of equalization charges of the lead-acid battery or the overcharge rate integrated value of the equalization charge of the lead-acid battery, it is possible to consider the progress of corrosion of a positive electrode and softening of an active material due to electrolyte loss and to provide the lead-acid battery life estimation method capable of accurately estimating the remaining life of the lead-acid battery.

Further, in the lead-acid battery life estimation method according to the present invention, in the equalization charge number calculation step, in a case where the equalization charge of the lead-acid battery is interrupted in the middle, the number of equalization charges is calculated based on a constant voltage (CV) charge time from when a CV charge, which is charging at a constant voltage, starts to when the equalization charge is interrupted and a CV time for equalization charge completion determination, and in the capacity turnover value calculation step, the equalization-charge-number-based correction coefficient is calculated based on the number of equalization charges calculated in the equalization charge number calculation step. As a result, in a case where the equalization charge is interrupted in the middle, the accurate number of equalization charges can be calculated, and as a result, the accurate equalization-charge-number-based correction coefficient can be calculated, and the remaining life of the lead-acid battery can be estimated with high accuracy.

In the lead-acid battery life estimation method according to the present invention, in the equalization charge number calculation step, in a case where the equalization charge of the lead-acid battery is interrupted in the middle, the number of equalization charges is calculated based on the charge rate when the equalization charge is interrupted and the charge rate for the equalization charge completion determination, and in the capacity turnover value calculation step, the equalization-charge-number-based correction coefficient is calculated based on the number of equalization charges calculated in the equalization charge number calculation step. As a result, in a case where the equalization charge is interrupted in the middle, the accurate number of equalization charges can be calculated, and as a result, the accurate equalization-charge-number-based correction coefficient can be calculated, and the remaining life of the lead-acid battery can be estimated with high accuracy.

In the lead-acid battery life estimation method of the present invention, the lead-acid battery is a bipolar lead-acid battery. Accordingly, it is possible to provide the lead-acid battery life estimation method capable of accurately estimating the remaining life of the bipolar lead-acid battery.

Brief Description of Drawings

FIG. 1 is a block diagram illustrating an overall configuration of lead-acid battery systems according to first and second embodiments of the present invention;
FIG. 2 is a block diagram illustrating an internal configuration of battery management units (BMUs) included in the lead-acid battery systems according to the first and second embodiments of the present invention illustrated in FIG. 1;
FIG. 3 is an explanatory diagram for describing an example of performing a charge, a discharge, and an equalization charge of a lead-acid battery together, and the number of equalization charges;
FIG. 4 is a block diagram illustrating internal configurations of a recording unit and a state determination unit included in the BMU illustrated in FIG. 2 in the lead-acid battery system according to the first embodiment of the present invention;
FIG. 5 is a diagram for describing an example of how to calculate the number of equalization charges based on a constant voltage (CV) charge time from when a CV charge starts to when the equalization charge is interrupted in a case where the equalization charge is interrupted in an example of performing the charge, discharge, and equalization charge of the lead-acid battery;
FIG. 6 is a block diagram illustrating an internal configuration of a capacity turnover value calculation unit included in the state determination unit illustrated in FIG. 4;
FIG. 7 is a flowchart illustrating a flow of processing in the state determination unit illustrated in FIG. 4;
FIG. 8 is a flowchart illustrating a flow of processing of step S1 (equalization charge number calculation step) in the flowchart illustrated in FIG. 7;
FIG. 9 is a flowchart illustrating a flow of processing of step S8 (capacity turnover value calculation step) in the flowchart illustrated in FIG. 7;
FIG. 10 is a diagram for describing an example of how to calculate the number of equalization charges based on a charge rate when the equalization charge is interrupted in a case where the equalization charge is interrupted in an example of performing the charge, discharge, and equalization charge of the lead-acid battery;
FIG. 11 is a flowchart illustrating a flow of another example of the processing of step S1 (equalization charge number calculation step) in the flowchart illustrated in FIG. 7;
FIG. 12 is an explanatory diagram for describing an example of performing the charge, discharge, and equalization charge of the lead-acid battery, and an overcharge rate integrated value;
FIG. 13 is a block diagram illustrating internal configurations of a recording unit and a state determination unit included in the BMU illustrated in FIG. 2 in the lead-acid battery system according to the second embodiment of the present invention;
FIG. 14 is a block diagram illustrating an internal configuration of a capacity turnover value calculation unit included in the state determination unit illustrated in FIG. 13;
FIG. 15 is a flowchart illustrating a flow of processing in the state determination unit illustrated in FIG. 13;
FIG. 16 is a flowchart illustrating a flow of processing of step S101 (overcharge rate integrated value calculation step) in the flowchart illustrated in FIG. 15;
FIG. 17 is a flowchart illustrating a flow of processing of step S108 (capacity turnover value calculation step) in the flowchart illustrated in FIG. 15;
FIG. 18 is a graph for describing an example of a cycle characteristic of a general lead-acid battery;
FIG. 19 is a graph illustrating an example of a relationship between a DOD representing a depth of discharge and a life of a storage battery; and
FIG. 20 is a graph illustrating an example of a relationship between the number of equalization charges and a cycle life of a predetermined bipolar lead-acid battery.

Description of Embodiments

Hereinafter, an embodiment of the present invention will be described in detail with reference to the drawings. Note that the embodiment described below illustrates an example of the present invention. In addition, various changes or improvements can be added to the present embodiment, and a mode to which such changes or improvements are added can also be included in the present invention. The embodiment and modifications thereof are included in the scope and gist of the invention, and are included in the scope of the invention described in the claims and its equivalents.

(First Embodiment)

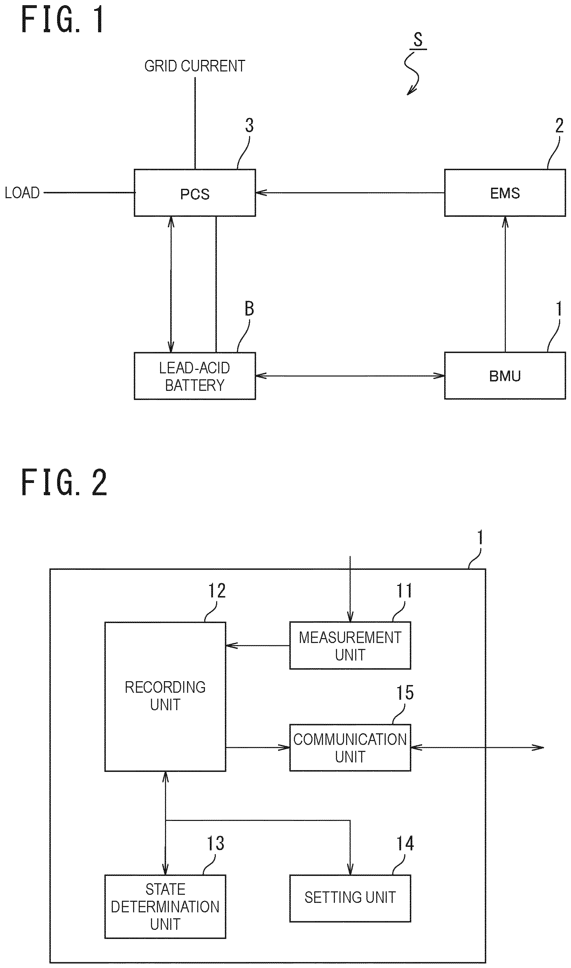

FIG. 1 illustrates an overall configuration of lead-acid battery systems according to a first embodiment of the present invention and a second embodiment described below.

A lead-acid battery system S illustrated in FIG. 1 is a system that stores, in a lead-acid battery B, a grid current generated by various power plants such as thermal power plants or from renewable energy such as wind power generation and transmitted, and transmits the power stored in the lead-acid battery B to a load such as a home, an office, or a factory as necessary. The lead-acid battery system S includes a BMU 1, an EMS 2, and a PCS 3 in addition to the lead-acid battery B.

The BMU 1 is a battery management unit and is a device that manages a voltage of each of cells included in the lead-acid battery B, a temperature of the entire lead-acid battery B, and the like. Thus, the BMU 1 can grasp a state of the lead-acid battery B via a sensor that is provided in the lead-acid battery B and acquires various types of information.

In addition, the BMU 1 estimates a remaining life of the lead-acid battery B by comparing a capacity turnover value from the beginning to the end of life with a capacity turnover value during operation. Therefore, the BMU 1 includes a life estimation program necessary for the estimation.

Note that a function of the BMU 1 is not limited to the function described here, and may include other functions such as managing the balance of voltages in the respective cells, for example.

The BMU 1 is a computer system having an arithmetic processing function, and can implement each function on software by executing various dedicated computer programs stored in advance in hardware. In addition, the BMU 1 may be installed near the lead-acid battery B, or may be configured to be managed on a cloud or managed remotely. A detailed configuration of the BMU 1 will be described later.

The EMS 2 is a so-called energy management system, and is a system that grasps, manages, and optimizes a use state of power energy. In addition, the PCS 3 is a power conditioning system, and serves a role of converting a direct current generated from a grid current or the like into an alternating current and adjusting the alternating current to an output to the load or a stable output suitable for storage in the lead-acid battery B.

The lead-acid battery B is a secondary battery using lead as an electrode. As the lead-acid battery B, a bipolar lead-acid battery is preferably applied, but any structure may be used, and the number of installations, an installation method, and the like are not limited, and any setting can be used. In the lead-acid battery B, information acquired from various sensors to be described later (sensor information) is transmitted to the BMU 1, but a transmission/reception device or the like for transmitting the acquired sensor information to the BMU 1 and receiving, for example, a command from the PCS 3 is provided.

The lead-acid battery B includes various sensors (not illustrated in FIG. 1) for acquiring corresponding operation history information. The various sensors are sensors that acquire information indicating an operation history or state of the lead-acid battery B such as a current, a voltage, or a temperature. These sensors may be provided for each unit or for each individual lead-acid battery B.

In the lead-acid battery system S according to the first embodiment and the second embodiment described below, the direct current from the grid current from the power plant such as a thermal power plant or renewable energy is converted into the alternating current in the PCS 3, and output to the load or storage in the lead-acid battery B is performed.

As will be described later, the BMU 1 estimates the remaining life of the lead-acid battery B, grasps a charge rate, the degree of deterioration, and the like of the lead-acid battery B, and issues an operation command to the EMS 2 according to the state of the lead-acid battery B. This operation command is further transmitted to the PCS 3 to appropriately issue a command for charging or discharging the lead-acid battery B and perform the above-described output to the load and the like.

As illustrated in FIG. 1, the BMU 1, the EMS 2, the PCS 3, and the lead-acid battery B are exemplified as four constituent elements of the lead-acid battery system S, but the constituent elements of the lead-acid battery system S are not limited thereto. It is also possible to impart the functions of the EMS 2 and the PCS 3 to the BMU 1, and in this case, the lead-acid battery system S is constituted by the BMU 1 and the lead-acid battery B.

Next, the BMU 1 will be described in more detail. FIG. 2 is a block diagram illustrating an internal configuration of the BMUs included in the lead-acid battery systems illustrated in FIG. 1 according to the first embodiment of the present invention and the second embodiment described below.

The BMU 1 includes a measurement unit 11, a recording unit 12, a state determination unit 13, a setting unit 14, and a communication unit 15.

The measurement unit 11 receives information regarding a measured value such as a current, a voltage, or a temperature measured via the above-described various sensors provided in the lead-acid battery B. Note that the measurement unit 11 may be set to continuously receive the above-described information, or may receive the above-described information between two time points arbitrarily set in advance. Alternatively, the measurement unit 11 may be set to periodically receive the information.

The recording unit 12 records information regarding the measured value received from the various sensors by the measurement unit 11, information exchanged with the EMS 2, information necessary for calculating the capacity turnover value during operation and the capacity turnover value from the beginning to the end of life (for example, a rated capacity or the like of the lead-acid battery B), a result of processing executed by the state determination unit 13 (the remaining life of the lead-acid battery B, the capacity turnover value during operation calculated by state determination unit 13, the number of equalization charges, and an overcharge rate integrated value), and the like.

The state determination unit 13 determines the state of the lead-acid battery B, specifically, estimates the remaining life of the lead-acid battery B by comparing the capacity turnover value from the beginning to the end of life and the capacity turnover value during operation. Here, as described above, the capacity turnover value is a value obtained by dividing a total discharge capacity by a rated capacity of a storage battery, and is used as a life index of the storage battery. The capacity turnover value from the beginning to the end of life is obtained by dividing the total discharge capacity from the beginning to the end of life by the rated capacity of the storage battery. For example, in FIG. 19, when a lead-acid battery having a rated capacity of 1000 Ah as indicated by an arrow X is dischargeable for 4500 cycles with a DOD of 70%, the capacity turnover value from the beginning to the end of life (hereinafter, referred to as a CT value from the beginning to the end of life) is total discharge capacity (1000 Ah $\times$ 70% $\times$ 4500 cycles)/rated capacity (1000 Ah) = 3150 (times). In addition, the capacity turnover value during operation is calculated by a method described below.

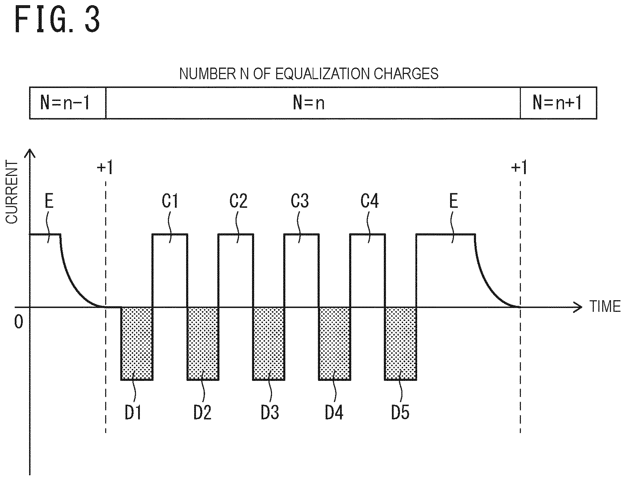

The processing in the state determination unit 13 is executed as needed in normal operation, for example. In FIG. 3, an example of performing a charge, a discharge, and an equalization charge of the lead-acid battery B is described together with the number of equalization charges. The equalization charge is one of charge methods performed to maintain the quality of the storage battery, and is performed to correct variations in cell voltage due to long-term use and equalize the cell voltages. In the first embodiment, as illustrated in FIG. 3, equalization charge E is performed once for five discharges (D1 to D5) and four normal charges (C1 to C4) .

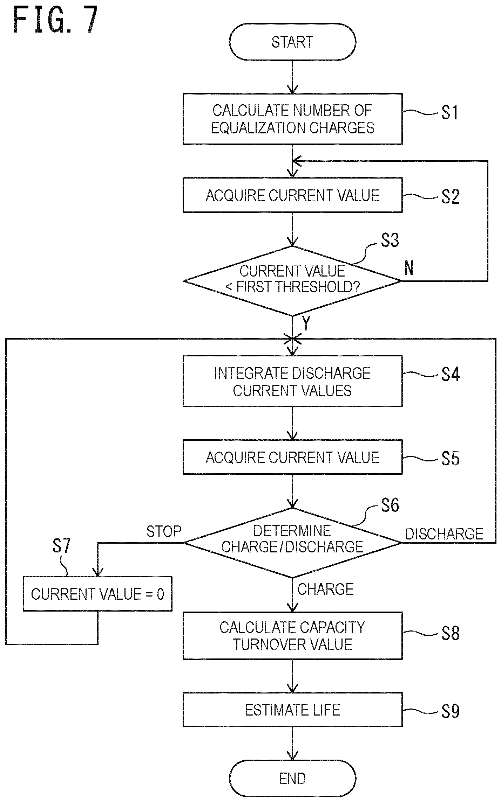

Then, the processing in the state determination unit 13 is executed for each time the equalization charge E is performed. Step S1 (equalization charge number calculation step) illustrated in FIG. 7 to be described later is executed at the time of processing of the previous (n-1-th) equalization charge before the current (n-th) equalization charge. At the time of processing of the current (n-th) equalization charge, steps S2 (current value acquisition step) to S9 (life estimation step) illustrated in FIG. 7 are executed for each of the discharges D1 to D5, and the remaining life of the lead-acid battery B is estimated by comparing the capacity turnover value from the beginning to the end of life and the capacity turnover value during operation.

The setting unit 14 sets, for example, a threshold or the like of a current value used for the discharge start determination and the discharge end determination, which is used when the state determination unit 13 determines the state of the lead-acid battery B, specifically, estimates the remaining life of the lead-acid battery B, and transmits the set information to the recording unit 12. In setting the threshold, an input unit and a display unit (not illustrated in FIG. 2) are used.

The communication unit 15 transmits the result of the processing in the state determination unit 13 recorded in the recording unit 12 to the EMS 2.

The BMU 1 is a computer system having an arithmetic processing function as described above and has a configuration in which a central processing unit (CPU), a read only memory (ROM), a random access memory (RAM), and an input/output interface are connected via a bus. In addition, the input unit and the display unit used by a person who manages the lead-acid battery system S are connected to the input/output interface, and each unit illustrated in FIG. 2 described above is connected to the input/output interface.

The CPU reads and executes a boot program for activating the BMU 1 from the ROM based on an input signal from the input unit, and reads various operating systems stored in the recording unit 12. The CPU may control the lead-acid battery B or the like based on an input signal from another external device (not illustrated in FIG. 2) via the input unit or the input/output interface.

Further, the CPU is a processing device that reads a program and data stored in the RAM, the recording unit 12, or the like and loads the program and the data into the RAM, and implements a series of processing such as calculation and processing of data necessary for estimating the remaining life of the lead-acid battery B based on a command of the program read from the RAM.

The input unit is implemented by an input device such as a touch panel to which a person who manages the lead-acid battery system S inputs various operations, and an input signal is created based on the operation of the manager and transmitted to the CPU via the bus.

The display unit is, for example, a liquid crystal display. The display unit receives an output signal from the CPU via the bus and displays a processing result of the CPU.

In a case where the BMU 1 itself is operated by remote control, for example, the input unit and the display unit do not have to be provided inside the BMU 1. The BMU 1 may have functions other than the above-described units.

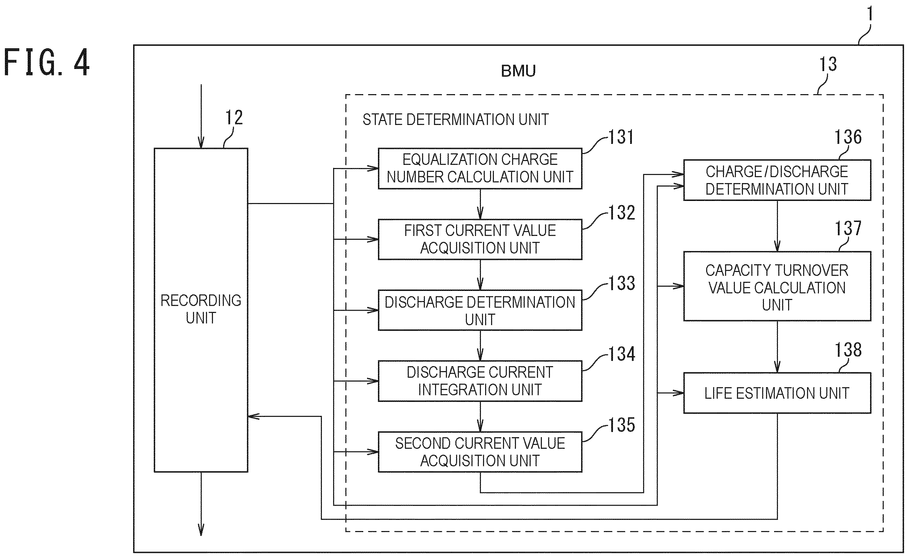

Next, internal configurations of the recording unit 12 and the state determination unit 13 will be described in more detail below. FIG. 4 is a block diagram illustrating the internal configurations of the recording unit 12 and the state determination unit 13 included in the BMU 1 illustrated in FIG. 2 in the lead-acid battery system S according to the first embodiment of the present invention.

The recording unit 12 is implemented by, for example, a semiconductor or a magnetic disk. The recording unit 12 records information regarding the measured value received from the various sensors by the measurement unit 11, such as information regarding a current value and a voltage value when the lead-acid battery B is charged or discharged, or information regarding the temperature of the lead-acid battery B, information exchanged with the EMS 2, information necessary for calculating the capacity turnover value during operation and the capacity turnover value from the beginning to the end of life (for example, the rated capacity or the like of the lead-acid battery B), a result of processing executed by the state determination unit 13 (the remaining life of the lead-acid battery B, the capacity turnover value during operation calculated by state determination unit 13, and the number of equalization charges), and the like.

The state determination unit 13 includes an equalization charge number calculation unit 131, a first current value acquisition unit 132, a discharge determination unit 133, a discharge current integration unit 134, a second current value acquisition unit 135, a charge/discharge determination unit 136, a capacity turnover value calculation unit 137, and a life estimation unit 138.

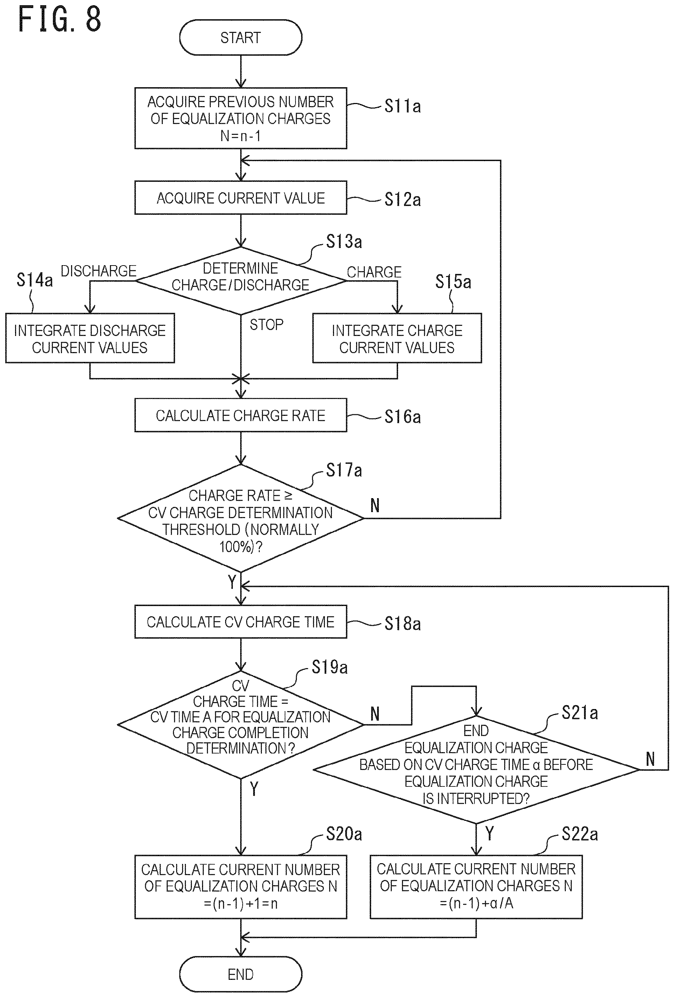

The equalization charge number calculation unit 131 calculates the current number N of equalization charges (N = (n - 1) + 1 = n, and N = (n - 1) + a/A) at the time of the processing of the previous (n-1-th) equalization charge before the current (n-th) equalization charge. Specific processing in the equalization charge number calculation unit 131 will be described later with reference to FIG. 8. Information regarding the calculated current number N of equalization charges (N = (n - 1) + 1 = n, and N = (n - 1) + a/A) is recorded in the recording unit 12. a is a constant voltage (CV) charge time from when CV change starts to when the equalization charge is interrupted, and A is a CV time A for equalization charge completion determination.

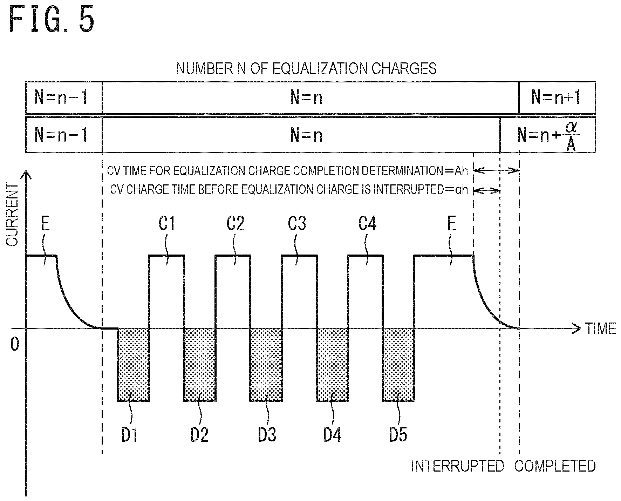

Here, FIG. 5 illustrates an example of how to calculate the number of equalization charges E based on the CV charge time a (hour) from when the CV charge starts to when the equalization charge is interrupted in a case where the equalization charge E is interrupted in an example of performing the charge, discharge, and equalization charge of the lead-acid battery B.

The equalization charge E is performed once for a predetermined number of discharges and a predetermined number of normal charges. In the example of FIG. 3, the equalization charge E is performed once for five discharges (D1 to D5) and four normal charges (C1 to C4). Therefore, in a case where the equalization charge E of the lead-acid battery B is completed in the processing of the previous (n-1-th) equalization charge, one is counted as the number of equalization charges, and one is added to the previous number (N = n - 1) of equalization charges to calculate the current number N of equalization charges (N = (n - 1) + 1 = n).

However, as illustrated in FIG. 5, the equalization charge E may be interrupted in the middle. For example, in a factory or the like that transmits power stored in the lead-acid battery B, a power failure may occur, and the equalization charge E may be urgently interrupted to transmit the power stored in the lead-acid battery B.

In a case where the equalization charge E of the lead-acid battery B is interrupted during the processing of the previous equalization charge, the equalization charge number calculation unit 131 counts a/A as the number of equalization charges based on the CV charge time a (hour) from when the CV charge, which is charging at a constant voltage, starts to when the equalization charge is interrupted, and the CV time A (hour) for the equalization charge completion determination, and adds a/A to the previous number (N = n - 1) of equalization charges to calculate the current number N of equalization charges (N = (n - 1) + a/A) . Here, the CV time A for the equalization charge completion determination is set to, for example, five hours.

In addition, the first current value acquisition unit 132 acquires information regarding a current value of the lead-acid battery B input to the recording unit 12 via the measurement unit 11 from the recording unit 12 from the start to the end of the processing in the state determination unit 13 at the time of the processing of the current (n-th) equalization charge.

In addition, the discharge determination unit 133 determines whether or not the discharge of the lead-acid battery B has started based on the current value of the lead-acid battery B acquired by the first current value acquisition unit 132. Specifically, in a case where the current value of the lead-acid battery B acquired by the first current value acquisition unit 132 is smaller than a first threshold, it is determined that the discharge has started, and in a case where the current value is equal to or larger than the first threshold, it is determined that the lead-acid battery B is in a stop state or a charge state. The first threshold is specifically a negative current value near 0 amperes, and in a case where the current value is smaller than the first threshold, it is determined that the discharge has started, and in a case where the current value is equal to or larger than the first threshold, it is determined that the lead-acid battery B is in the stop state or the charge state. The first threshold for the discharge start determination is set by the setting unit 14 and recorded in the recording unit 12, and the discharge determination unit 133 acquires information regarding the first threshold from the recording unit 12.

In addition, the discharge current integration unit 134 integrates discharge current values after the start of the discharge of the lead-acid battery B, and calculates an integrated discharge capacity value after the start of the discharge of the lead-acid battery B.

The second current value acquisition unit 135 acquires, from the recording unit 12, information regarding the current value of the lead-acid battery B input to the recording unit 12 via the measurement unit 11 from the start to the end of the processing in the state determination unit 13.

In addition, the charge/discharge determination unit 136 determines whether the lead-acid battery B is in a discharge state, the stop state, or the charge state based on the current value of the lead-acid battery B acquired by the second current value acquisition unit 135.

Here, in a case where the current value of the lead-acid battery B acquired by the second current value acquisition unit 135 is smaller than the first threshold (the current value < a first threshold), the charge/discharge determination unit 136 determines that the lead-acid battery B is in the discharge state,

in a case where the first threshold ≤ the current value ≤ a second threshold, the charge/discharge determination unit 136 determines that the lead-acid battery B is in the stop state, and
in a case where the current value > the second threshold, the charge/discharge determination unit 136 determines that the lead-acid battery B is in the charge state.

The first threshold is the same value as the above-described first threshold, and the second threshold is a positive current value near 0 amperes.

Next, in a case where it is determined by the charge/discharge determination unit 136 that the lead-acid battery B is in the charge state, the capacity turnover value calculation unit 137 calculates the capacity turnover value during operation (hereinafter, referred to as a CT value during operation).

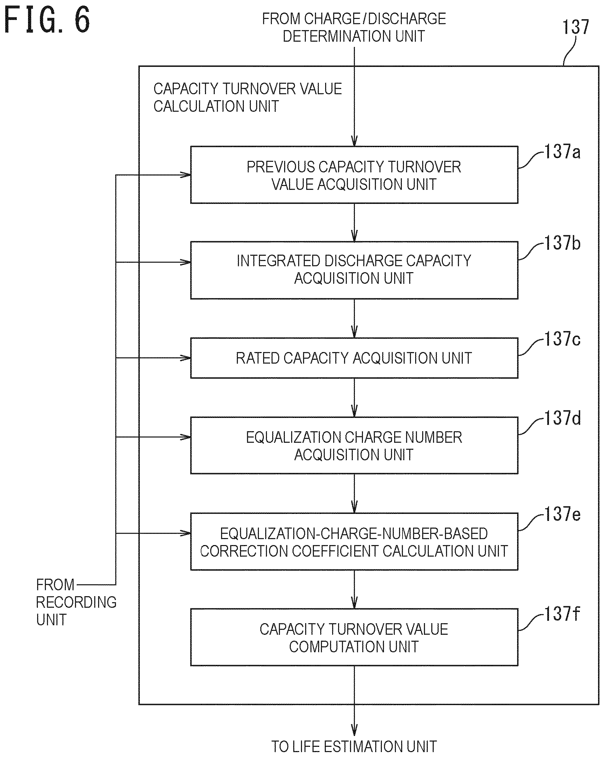

An internal configuration of the capacity turnover value calculation unit 137 will be described in more detail below. FIG. 6 is a block diagram illustrating an internal configuration of the capacity turnover value calculation unit 137 included in the state determination unit 13 illustrated in FIG. 4.

The capacity turnover value calculation unit 137 includes a previous capacity turnover value acquisition unit 137a, an integrated discharge capacity acquisition unit 137b, a rated capacity acquisition unit 137c, an equalization charge number acquisition unit 137d, an equalization-charge-number-based correction coefficient calculation unit 137e, and a capacity turnover value computation unit 137f.

In a case where it is determined by the charge/discharge determination unit 136 that the lead-acid battery B is in the charge state, the previous capacity turnover value acquisition unit 137a acquires, from the recording unit 12, a capacity turnover value before the start of the processing in the state determination unit 13 (hereinafter, referred to as a previous CT value), at the time of the processing of the current equalization charge. The previous CT value is a CT value during operation calculated by the capacity turnover value calculation unit 137 at the time of the previous processing in the state determination unit 13, and already input from the capacity turnover value calculation unit 137 to the recording unit 12.

In addition, the integrated discharge capacity acquisition unit 137b acquires information regarding the integrated discharge capacity value from the start of the discharge of the lead-acid battery B calculated by the discharge current integration unit 134.

Further, the rated capacity acquisition unit 137c acquires information regarding the rated capacity (Ah) of the lead-acid battery B from the recording unit 12.

In addition, the equalization charge number acquisition unit 137d acquires, from the recording unit 12, information regarding the current number N of equalization charges (N = (n - 1) + 1 = n, and N = (n - 1) + a/A) calculated by the equalization charge number calculation unit 131.

In addition, the equalization-charge-number-based correction coefficient calculation unit 137e calculates an equalization-charge-number-based correction coefficient $K_{CN}$ by the following Formula (1) based on the information regarding the current number N of equalization charges (N = (n - 1) + 1 = n, and N = (n - 1) + a/A) acquired by the equalization charge number acquisition unit 137d.

$$K_{CN} = 1 + (N - 1) \times a \quad \cdots \quad (1)$$

Here, a is, for example, $a = 2.14 \times 10^{-4}$.

However, when N < 1, $K_{CN} = 1$.

Furthermore, the capacity turnover value computation unit 137f calculates the CT value during operation by the following Formula (2) using the previous CT value acquired by the previous capacity turnover value acquisition unit 137a, the integrated discharge capacity from the start of the discharge of the lead-acid battery B acquired by the integrated discharge capacity acquisition unit 137b, the rated capacity (Ah) of the lead-acid battery B acquired by the rated capacity acquisition unit 137c, and the equalization-charge-number-based correction coefficient $K_{CN}$ calculated by the equalization-charge-number-based correction coefficient calculation unit 137e.

[Mathematical Formula 1]

$$\text{CT value during operation} = \text{Previous CT value} + \frac{\text{Integrated discharge capacity}}{\text{Rated capacity}} \times K_{CN} \quad \cdots \quad (2)$$

Then, the life estimation unit 138 of the state determination unit 13 estimates the remaining life of the lead-acid battery B by comparing the CT value from the beginning to the end of life acquired from the recording unit 12 with the CT value during operation calculated by the capacity turnover value calculation unit 137. That is, the life estimation unit 138 estimates the remaining life of the lead-acid battery B from a CT value obtained by subtracting the CT value during operation from the CT value from the beginning to the end of life.

Then, the life estimation unit 138 records an estimation result of the life estimation unit 138 including information regarding the CT value during operation in the recording unit 12.

As described above, in the lead-acid battery system S according to the first embodiment, the capacity turnover value calculation unit 137 calculates the CT value during operation by using the equalization-charge-number-based correction coefficient $K_{CN}$ calculated based on the number of equalization charges E (the current number N of equalization charges (N = (n - 1) + 1 = n, and N = (n - 1) + a/A)) calculated by the equalization charge number calculation unit 131 that calculates the number of equalization charges E of the lead-acid battery B. As a result, by calculating the CT value during operation in consideration of the number of equalization charges E of the lead-acid battery B, it is possible to consider the progress of corrosion of a positive electrode and softening of an active material due to electrolyte loss and to provide the lead-acid battery system S capable of accurately estimating the remaining life of the lead-acid battery.

In addition, in the lead-acid battery system S according to the first embodiment, in a case where the equalization charge E of the lead-acid battery B is interrupted in the middle, the equalization charge number calculation unit 131 calculates the number of equalization charges E (the current number N of equalization charges (N = (n - 1) + a/A)) based on the CV charge time a (hour) from when the CV charge, which is charging at a constant voltage, starts to when the equalization charge is interrupted and the CV time A (hour) for the equalization charge completion determination, and the capacity turnover value calculation unit 137 calculates the equalization-charge-number-based correction coefficient $K_{CN}$ based on the number of equalization charges E (the current number N of equalization charges (N = (n - 1) + a/A)) calculated by the equalization charge number calculation unit 131. As a result, in a case where the equalization charge E is interrupted in the middle, the accurate number of equalization charges E can be calculated, and as a result, the accurate equalization-charge-number-based correction coefficient $K_{CN}$ can be calculated, and the remaining life of the lead-acid battery B can be estimated with high accuracy.

In the lead-acid battery system S according to the first embodiment, in a case where the lead-acid battery B is a bipolar lead-acid battery, it is possible to provide the lead-acid battery system S capable of accurately estimating the remaining life of the bipolar lead-acid battery.

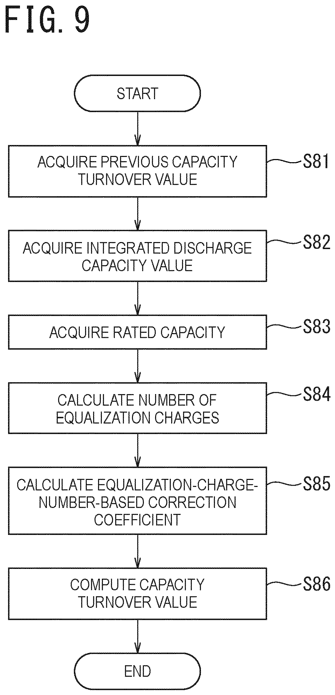

Next, a lead-acid battery life estimation method according to the first embodiment will be described with reference to a flowchart illustrating a flow of the processing in the state determination unit illustrated in FIG. 7, a flowchart illustrating a flow of processing of step S1 (equalization charge number calculation step) in the flowchart of FIG. 7 illustrated in FIG. 8, and a flowchart illustrating a flow of processing of step S8 (capacity turnover value calculation step) in the flowchart of FIG. 7 illustrated in FIG. 9.

First, in step S1, the equalization charge number calculation unit 131 of the state determination unit 13 calculates the current number N of equalization charges (N = (n - 1) + 1 = n, and N = (n - 1) + a/A) at the time of the processing of the previous (n-1-th) equalization charge before the current (n-th) equalization charge (equalization charge number calculation step).

Details of the processing of step S1 in the equalization charge number calculation unit 131 will be described with reference to FIG. 8.

First, in step S11a, the equalization charge number calculation unit 131 acquires information regarding the previous number (N = n - 1) of equalization charges from the recording unit 12.

Next, in step S12a, the equalization charge number calculation unit 131 acquires, from the recording unit 12, information regarding the current value of the lead-acid battery B input to the recording unit 12 via the measurement unit 11.

Next, in step 13a, the equalization charge number calculation unit 131 determines whether the lead-acid battery B is in the discharge state, the stop state, or the charge state based on the current value of the lead-acid battery B acquired in step S12a.

Here, in a case where the current value of the lead-acid battery B acquired in step S12a is smaller than the first threshold (the current value < the first threshold), the equalization charge number calculation unit 131 determines that the lead-acid battery B is in the discharge state,

in a case where the first threshold ≤ the current value ≤ the second threshold, the equalization charge number calculation unit 131 determines that the lead-acid battery B is in the stop state, and
in a case where the current value > the second threshold, the equalization charge number calculation unit 131 determines that the lead-acid battery B is in the charge state.

The first threshold is a negative current value near 0 amperes, and the second threshold is a positive current value near 0 amperes.

In a case where it is determined that the lead-acid battery B is in the discharge state, the processing proceeds to step S14a. In a case where it is determined that the lead-acid battery B is in the charge state, the processing proceeds to step S15a. In a case where it is determined that the lead-acid battery B is in the stop state, the processing proceeds to step S16a.

Then, in step S14a, the equalization charge number calculation unit 131 integrates the discharge current values from the start of the discharge of the lead-acid battery B acquired in step S12a, and calculates the integrated discharge capacity value from the start of the discharge of the lead-acid battery B.

In step S15a, charge current values from the start of the charge of the lead-acid battery B acquired in step S12a are integrated, and an integrated charge capacity value from the start of the charge of the lead-acid battery B is calculated.

In step S16a, the equalization charge number calculation unit 131 calculates a charge rate based on the integrated discharge capacity value calculated in step S14a and the integrated charge capacity value calculated in step S15a. Here, the charge rate is calculated by dividing the total charge amount by the total discharge amount.

Next, in step S17a, the equalization charge number calculation unit 131 determines whether or not the charge rate calculated in step S16a is equal to or more than a CV charge determination threshold (usually 100%).

Then, in a case where it is determined that the charge rate is equal to or more than the CV charge determination threshold, the processing proceeds to step S18a, and in a case where it is determined that the charge rate is less than the CV charge determination threshold, the processing returns to step S12a.

In step S18a, the equalization charge number calculation unit 131 calculates the CV charge time of the CV charge which is charging at a constant voltage.

Next, in step S19a, the equalization charge number calculation unit 131 determines whether or not the CV charge time calculated in step S18a has reached the CV time A (hour) for the equalization charge completion determination.

Then, in a case where the CV charge time calculated in step S18a has reached the CV time A (hour) for the equalization charge completion determination, the processing proceeds to step S20a, and in a case where the CV charge time has not reached the CV time A (hour) for the equalization charge completion determination, the processing proceeds to step S21a.

In step S20a, the equalization charge number calculation unit 131 determines that the equalization charge E of the lead-acid battery B is completed, counts one as the number of equalization charges, and adds one to the previous number N of equalization charges (N = (n - 1)) to calculate the current number N of equalization charges (N = (n - 1) + 1 = n).

On the other hand, in step S21a, the equalization charge number calculation unit 131 determines whether or not to end the equalization charge E based on the CV charge time a (hour) before the equalization charge E is interrupted. Then, in a case where the equalization charge E is to be ended, the processing proceeds to step S22a, and in a case where the equalization charge E is not to be ended, the processing returns to step S18a.

Then, in step S22a, the equalization charge number calculation unit 131 determines that the equalization charge E of the lead-acid battery B is interrupted, counts a/A as the number of equalization charges based on the CV charge time a (hour) from when the CV charge, which is charging at a constant voltage, starts to when the equalization charge is interrupted and the CV time A (hour) for the equalization charge completion determination, and adds a/A to the previous number (N = (n - 1)) of equalization charges to calculate the current number N of equalization charges (N = (n - 1) + a/A) .

Then, information regarding the calculated current number N of equalization charges (N = (n - 1) + 1 = n, and N = (n - 1) + a/A) is transmitted to the recording unit 12.

Accordingly, the processing of step S1 in the equalization charge number calculation unit 131 ends.

Next, in step S2, the first current value acquisition unit 132 of the state determination unit 13 acquires, from the recording unit 12, information regarding the current value of the lead-acid battery B input to the recording unit 12 via the measurement unit 11 from the start to the end of the processing in the state determination unit 13 at the time of the processing of the current (n-th) equalization charge (first current value acquisition step).

Next, in step S3, the discharge determination unit 133 of the state determination unit 13 determines whether or not the discharge of the lead-acid battery B has started based on the current value of the lead-acid battery B acquired in step S2 (discharge determination step). Specifically, in a case where the current value of the lead-acid battery B acquired in step S2 is smaller than the first threshold, it is determined that the discharge has started, and in a case where the current value is equal to or larger than the first threshold, it is determined that the lead-acid battery B is in the stop state or the charge state. The first threshold is specifically a negative current value near 0 amperes, and in a case where the current value is smaller than the first threshold, it is determined that the discharge has started, and in a case where the current value is equal to or larger than the first threshold, it is determined that the lead-acid battery B is in the stop state or the charge state.

Next, in step S4, the discharge current integration unit 134 of the state determination unit 13 integrates the discharge current values from the start of the discharge of the lead-acid battery B, and calculates the integrated discharge capacity value from the start of the discharge of the lead-acid battery B (integrated discharge capacity value calculation step).

Next, in step S5, the second current value acquisition unit 135 of the state determination unit 13 acquires, from the recording unit 12, information regarding the current value of the lead-acid battery B input to the recording unit 12 via the measurement unit 11 from the start to the end of the processing in the state determination unit 13 (second current value acquisition step).

Next, in step S6, the charge/discharge determination unit 136 of the state determination unit 13 determines whether the lead-acid battery B is in the discharge state, the stop state, or the charge state based on the current value of the lead-acid battery B acquired in step S5 (charge/discharge determination step).

Here, in a case where the current value of the lead-acid battery B acquired in step S5 is smaller than the first threshold (the current value < a first threshold), the charge/discharge determination unit 136 determines that the lead-acid battery B is in the discharge state,

in a case where the first threshold ≤ the current value ≤ a second threshold, the charge/discharge determination unit 136 determines that the lead-acid battery B is in the stop state, and

in a case where the current value > the second threshold, the charge/discharge determination unit 136 determines that the lead-acid battery B is in the charge state.

The first threshold is the same value as the above-described first threshold, and the second threshold is a positive current value near 0 amperes.

In a case where it is determined that the lead-acid battery B is in the discharge state, the processing returns to step S4. In a case where it is determined that the lead-acid battery B is in the stop state, the processing proceeds to step S7. In a case where it is determined that the lead-acid battery B is in the charge state, the processing proceeds to step S8.

In step S7, the current value is set to 0 assuming that the lead-acid battery B is in the stop state, and the processing returns to step S4.

In step S8, the capacity turnover value calculation unit 137 of the state determination unit 13 calculates the capacity turnover value during operation (hereinafter, referred to as the CT value during operation) (capacity turnover value calculation step).

A detailed flow of the processing of step S8 in the capacity turnover value calculation unit 137 will be described with reference to FIG. 9.

First, in step S81, the previous capacity turnover value acquisition unit 137a of the capacity turnover value calculation unit 137 acquires, from the recording unit 12, the capacity turnover value before the start of the processing in the state determination unit 13 (hereinafter, referred to as the previous CT value) in the processing of the current (n-th) equalization charge (previous capacity turnover value acquisition step). The previous CT value is a CT value during operation calculated by the capacity turnover value calculation unit 137 at the time of the previous processing in the state determination unit 13, and already input from the capacity turnover value calculation unit 137 to the recording unit 12.

Next, in step S82, the integrated discharge capacity acquisition unit 137b of the capacity turnover value calculation unit 137 acquires information regarding the integrated discharge capacity value from the start of the discharge of the lead-acid battery B calculated in step S4 (integrated discharge capacity value acquisition step).

Next, in step S83, the rated capacity acquisition unit 137c of the capacity turnover value calculation unit 137 acquires information regarding the rated capacity (Ah) of the lead-acid battery B from the recording unit 12. Next, in step S84, the equalization charge number acquisition unit 137d of the capacity turnover value calculation unit 137 acquires information regarding the current number N of equalization charges (N = (n - 1) + 1 = n, and N = (n - 1) + a/A) calculated in step S1 from the recording unit 12 (equalization charge number acquisition step).

Next, in step S85, the equalization-charge-number-based correction coefficient calculation unit 137e of the capacity turnover value calculation unit 137 calculates the equalization-charge-number-based correction coefficient $K_{CN}$ by Formula (1) described above based on the information regarding the current number N of equalization charges (N = (n - 1) + 1 = n, and N = (n - 1) + a/A) acquired in step S84 (equalization-charge-number-based correction coefficient calculation step).

Next, in step S86, the capacity turnover value computation unit 137f of the capacity turnover value calculation unit 137 calculates the CT value during operation by Formula (2) described above using the previous CT value acquired in step S81, the integrated discharge capacity from the start of the discharge of the lead-acid battery B acquired in step S82, the rated capacity (Ah) of the lead-acid battery B acquired in step S83, and the equalization-charge-number-based correction coefficient $K_{CN}$ calculated in step S85 (capacity turnover value computation step).

As a result, the processing of step S8 in the capacity turnover value calculation unit 137 ends.

In step S9, the life estimation unit 138 of the state determination unit 13 estimates the remaining life of the lead-acid battery B by comparing the CT value from the beginning to the end of life acquired from the recording unit 12 with the CT value during operation calculated in step S8 (life estimation step). That is, the life estimation unit 138 estimates the remaining life of the lead-acid battery B from a CT value obtained by subtracting the CT value during operation from the CT value from the beginning to the end of life.

Then, the life estimation unit 138 records an estimation result of the life estimation unit 138 including information regarding the CT value during operation in the recording unit 12.

As described above, in the lead-acid battery life estimation method according to the first embodiment, in the capacity turnover value calculation step (step S8), the CT value during operation is calculated using the equalization-charge-number-based correction coefficient $K_{CN}$ calculated based on the number of equalization charges E (the current number N of equalization charges (N = (n - 1) + 1 = n, and N = (n - 1) + a/A)) calculated in the equalization charge number calculation step (step S1) of calculating the number of equalization charges E of the lead-acid battery B. As a result, by calculating the CT value during operation in consideration of the number of equalization charges E of the lead-acid battery B, it is possible to consider the progress of corrosion of a positive electrode and softening of an active material due to electrolyte loss and to provide the lead-acid battery life estimation method capable of accurately estimating the remaining life of the lead-acid battery B.

In addition, in the lead-acid battery life estimation method according to the first embodiment, in the equalization charge number calculation step (step S1), in a case where the equalization charge E of the lead-acid battery B is interrupted in the middle, the number of equalization charges E (the current number N of equalization charges (N = (n - 1) + a/A)) is calculated based on the CV charge time a (hour) from when the CV charge, which is charging with a constant voltage, starts to when the equalization charge is interrupted and the CV time A (hour) for the equalization charge completion determination, and in the capacity turnover value calculation step (step S8), the equalization-charge-number-based correction coefficient $K_{CN}$ based on the number of equalization charges E (the current number N of equalization charges (N (N = (n - 1) + a/A)))) calculated in the equalization charge number calculation step (step S1). As a result, in a case where the equalization charge E is interrupted in the middle, the accurate number of equalization charges E can be calculated, and as a result, the accurate equalization-charge-number-based correction coefficient $K_{CN}$ can be calculated, and the remaining life of the lead-acid battery B can be estimated with high accuracy.

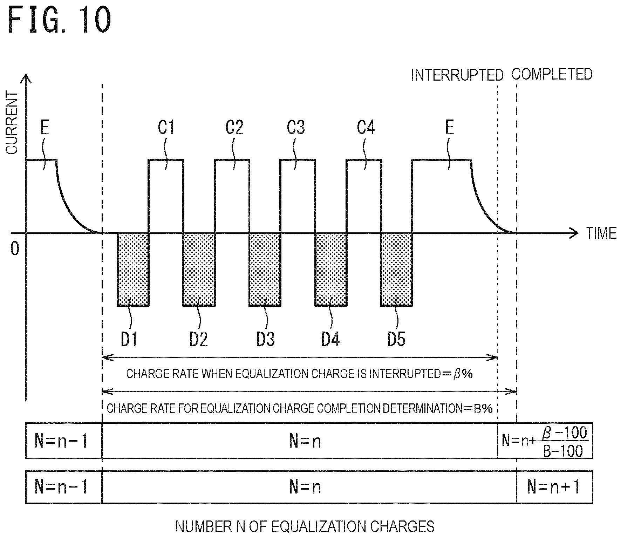

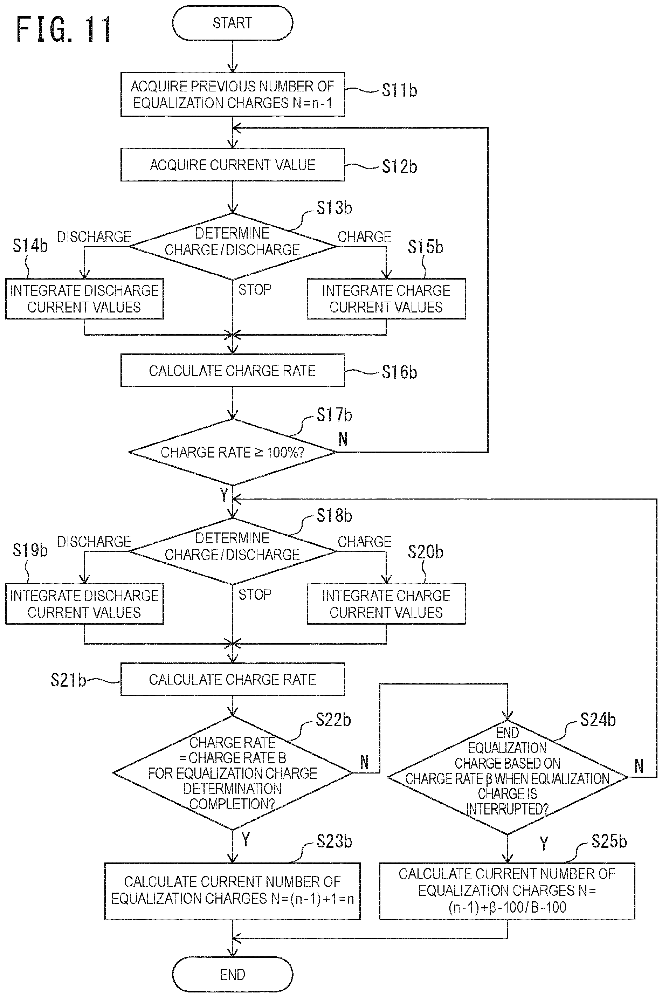

Next, a modification of the lead-acid battery system S and the lead-acid battery life estimation method will be described with reference to FIGS. 10 and 11. FIG. 10 is a diagram for describing an example of how to calculate the number of equalization charges based on the charge rate when the equalization charge is interrupted in a case where the equalization charge E is interrupted in an example of performing the charge, discharge, and equalization charge of the lead-acid battery B. FIG. 11 is a flowchart illustrating a flow of another example of the processing of step S1 (equalization charge number calculation step) in the flowchart illustrated in FIG. 7.

In the lead-acid battery system S and the lead-acid battery life estimation method according to the first embodiment, as described above, in a case where the equalization charge E is interrupted, the number of equalization charges E (the current number N of equalization charges (N = (n - 1) + a/A)) is calculated based on the CV charge time a (hour) from when the CV charge, which is charging at a constant voltage, starts to when the equalization charge E is interrupted and the CV time A (hour) for the equalization charge completion determination.

On the other hand, the modification of the lead-acid battery system S and the lead-acid battery life estimation method are different in that in a case where the equalization charge E of the lead-acid battery B is interrupted in the middle, the number of equalization charges (the current number N of equalization charges (N = (n - 1) + (β - 100)/(B - 100)) is calculated based on a charge rate β when the equalization charge E is interrupted and a charge rate B for the equalization charge completion determination.

More specifically, in the modification, in step S1 (equalization charge number calculation step) illustrated in FIG. 7, the equalization charge number calculation unit 131 of the state determination unit 13 calculates the current number N of equalization charges (N = (n - 1) + 1 = n, and N = (n - 1) + (β - 100)/(B - 100)) at the time of the processing of the previous (n-1-th) equalization charge before the current (n-th) equalization charge.

Details of the processing of step S1 in the equalization charge number calculation unit 131 will be described with reference to FIG. 11.

First, in step S11b, the equalization charge number calculation unit 131 acquires information regarding the previous number (N = n - 1) of equalization charges from the recording unit 12.

Next, in step S12b, the equalization charge number calculation unit 131 acquires, from the recording unit 12, information regarding the current value of the lead-acid battery B input to the recording unit 12 via the measurement unit 11.

Next, in step 13b, the equalization charge number calculation unit 131 determines whether the lead-acid battery B is in the discharge state, the stop state, or the charge state based on the current value of the lead-acid battery B acquired in step S12b.

Here, in a case where the current value of the lead-acid battery B acquired in step S12b is smaller than the first threshold (the current value < the first threshold), the equalization charge number calculation unit 131 determines that the lead-acid battery B is in the discharge state,

in a case where the first threshold ≤ the current value ≤ the second threshold, the equalization charge number calculation unit 131 determines that the lead-acid battery B is in the stop state, and
in a case where the current value > the second threshold, the equalization charge number calculation unit 131 determines that the lead-acid battery B is in the charge state.

The first threshold is a negative current value near 0 amperes, and the second threshold is a positive current value near 0 amperes.

In a case where it is determined that the lead-acid battery B is in the discharge state, the processing proceeds to step S14b. In a case where it is determined that the lead-acid battery B is in the charge state, the processing proceeds to step S15b. In a case where it is determined that the lead-acid battery B is in the stop state, the processing proceeds to step S16b.

Then, in step S14b, the equalization charge number calculation unit 131 integrates the discharge current values from the start of the discharge of the lead-acid battery B acquired in step S12b, and calculates the integrated discharge capacity value from the start of the discharge of the lead-acid battery B.

In step S15b, the equalization charge number calculation unit 131 integrates the charge current values from the start of the charge of the lead-acid battery B acquired in step S12b, and calculates the integrated charge capacity value from the start of the charge of the lead-acid battery B.

In step S16b, the equalization charge number calculation unit 131 calculates a charge rate based on the integrated discharge capacity value calculated in step S14b and the integrated charge capacity value calculated in step S15b. Here, the charge rate is calculated by dividing the total charge amount by the total discharge amount.

Next, in step 17b, the equalization charge number calculation unit 131 determines whether or not the charge rate calculated in step S16b is equal to or more than 100%.

Then, in a case where it is determined that the charge rate is equal to or more than 100%, the processing proceeds to step S18b, and in a case where it is determined that the charge rate is less than 100%, the processing returns to step S12b.

In step S18b, the equalization charge number calculation unit 131 determines whether the lead-acid battery B is in the discharge state, the stop state, or the charge state based on the current value of the lead-acid battery B acquired in step S12b.

Here, in a case where the current value of the lead-acid battery B acquired in step S12b is smaller than the first threshold (the current value < the first threshold), the equalization charge number calculation unit 131 determines that the lead-acid battery B is in the discharge state,

in a case where the first threshold $\leq$ the current value $\leq$ the second threshold, the equalization charge number calculation unit 131 determines that the lead-acid battery B is in the stop state, and

in a case where the current value > the second threshold, the equalization charge number calculation unit 131 determines that the lead-acid battery B is in the charge state.

The first threshold is a negative current value near 0 amperes, and the second threshold is a positive current value near 0 amperes.

In a case where it is determined that the lead-acid battery B is in the discharge state, the processing proceeds to step S19b. In a case where it is determined that the lead-acid battery B is in the charge state, the processing proceeds to step S20b. In a case where it is determined that the lead-acid battery B is in the stop state, the processing proceeds to step S21b.

Then, in step S19b, the equalization charge number calculation unit 131 integrates the discharge current values from the start of the discharge of the lead-acid battery B acquired in step S12b, and calculates the integrated discharge capacity value from the start of the discharge of the lead-acid battery B.

In step S20b, the equalization charge number calculation unit 131 integrates the charge current values from the start of the charge of the lead-acid battery B acquired in step S12ba, and calculates the integrated charge capacity value from the start of the charge of the lead-acid battery B.

In step S21b, the equalization charge number calculation unit 131 calculates a charge rate based on the integrated discharge capacity value calculated in step S19b and the integrated charge capacity value calculated in step S20b.

Then, in step S22b, the equalization charge number calculation unit 131 determines whether or not the charge rate calculated in step S21b has reached the charge rate $\beta$ (%) for the equalization charge completion determination.

Then, in a case where the charge rate calculated in step S21b has reached the charge rate $\beta$ (%) for the equalization charge completion determination, the processing proceeds to step 23b, and in a case where the charge rate has not reached the charge rate $\beta$ (%) for the equalization charge completion determination, the processing proceeds to step S24b.

In step S23b, the equalization charge number calculation unit 131 determines that the equalization charge E of the lead-acid battery B is completed, counts one as the number of equalization charges, and adds one to the previous number N of equalization charges (N = (n - 1)) to calculate the current number N of equalization charges (N = (n - 1) + 1 = n).

On the other hand, in step S24b, the equalization charge number calculation unit 131 determines whether or not to end the equalization charge E based on the charge rate $\beta$ when the equalization charge E is interrupted. Then, in a case where the equalization charge E is to be ended, the processing proceeds to step S25b, and in a case where the equalization charge E is not to be ended, the processing returns to step S18b.

In step S25b, the equalization charge number calculation unit 131 determines that the equalization charge E of the lead-acid battery B is interrupted, counts (β - 100)/(B - 100) as the number of equalization charges based on the charge rate β (%) when the equalization charge E is interrupted and the charge rate B (%) for the equalization charge completion determination, and adds (β - 100)/(B - 100) to the previous number (N = n - 1) of equalization charges to calculate the current number N of equalization charges

$$(N = (n - 1) + (\beta - 100)/(B - 100)).$$

Accordingly, the processing of step S1 in the equalization charge number calculation unit 131 ends.

As described above, in the modification of the lead-acid battery system S and the lead-acid battery life estimation method, in a case where the equalization charge E of the lead-acid battery B is interrupted in the middle, the number of equalization charges (the current number N of equalization charges (N = (n - 1) + (β - 100)/(B - 100)) is calculated based on a charge rate β when the equalization charge E is interrupted and a charge rate B for the equalization charge completion determination. Then, the capacity turnover value calculation unit 137 calculates the equalization-charge-number-based correction coefficient $K_{CN}$ based on the calculated number of equalization charges (the current number N of equalization charges (N = (n - 1) + (β - 100)/(B - 100))).

As a result, in a case where the equalization charge E is interrupted in the middle, the accurate number of equalization charges E can be calculated, and as a result, the accurate equalization-charge-number-based correction coefficient $K_{CN}$ can be calculated, and the remaining life of the lead-acid battery B can be estimated with high accuracy.

(Second Embodiment)

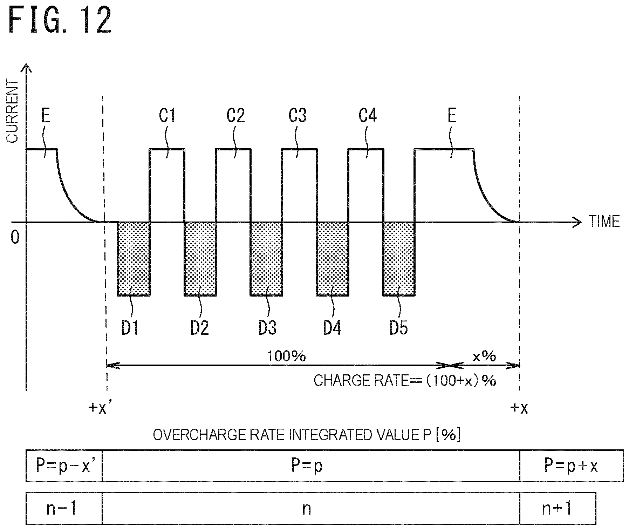

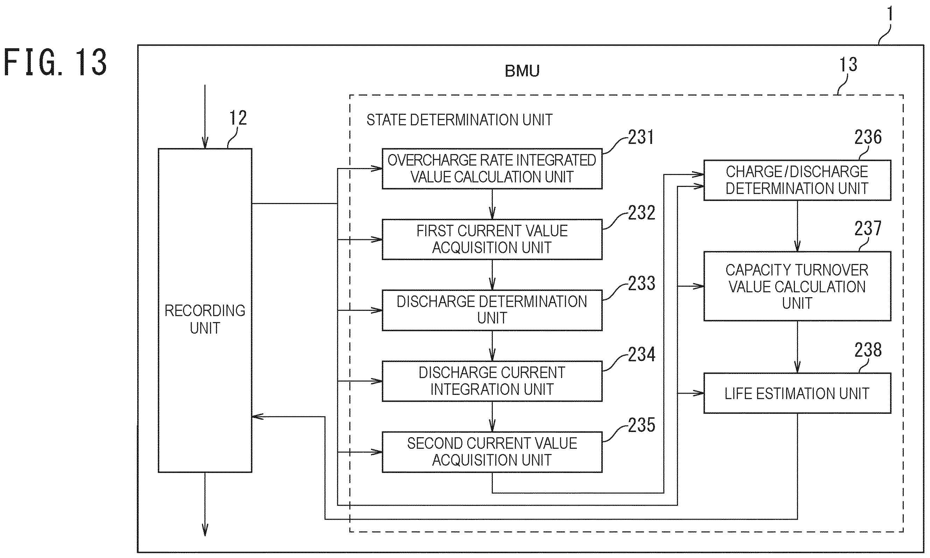

Next, the lead-acid battery system and a lead-acid battery life estimation method according to the second embodiment of the present invention will be described with reference to FIGS. 12 to 17. FIG. 12 is an explanatory diagram for describing an example of performing a charge, a discharge, and an equalization charge of a lead-acid battery, and an overcharge rate integrated value. FIG. 13 is a block diagram illustrating internal configurations of a recording unit and a state determination unit included in the BMU illustrated in FIG. 2 in the lead-acid battery system according to the second embodiment of the present invention.

The lead-acid battery system S according to the second embodiment has the same basic configuration as the lead-acid battery system S according to the first embodiment, and is different from the lead-acid battery system S according to the first embodiment in a configuration of the state determination unit 13.

Similarly to the state determination unit 13 in the lead-acid battery system S according to the first embodiment, the state determination unit 13 in the lead-acid battery system S according to the second embodiment determines a state of a lead-acid battery B, specifically, estimates a remaining life of the lead-acid battery B by comparing a capacity turnover value from the beginning to the end of life and a capacity turnover value during operation. However, the state determination unit 13 in the lead-acid battery system S according to the second embodiment is different from the state determination unit 13 in the lead-acid battery system S according to the first embodiment in that an overcharge rate integrated value calculation unit 231 that calculates an overcharge rate integrated value of the equalization charge E of the lead-acid battery B is included instead of the equalization charge number calculation unit 131. A capacity turnover value calculation unit 237 of the state determination unit 13 in the lead-acid battery system S according to the second embodiment is different from the lead-acid battery system S according to the first embodiment in that a capacity turnover value during operation is calculated using a charge-rate-based correction coefficient $K_{CP}$ calculated based on the overcharge rate integrated value of the equalization charge E calculated by the overcharge rate integrated value calculation unit 231.

As illustrated in FIG. 13, the state determination unit 13 in the lead-acid battery system S according to the second embodiment includes the overcharge rate integrated value calculation unit 231, a first current value acquisition unit 232, a discharge determination unit 233, a discharge current integration unit 234, a second current value acquisition unit 235, a charge/discharge determination unit 236, the capacity turnover value calculation unit 237, and a life estimation unit 238.

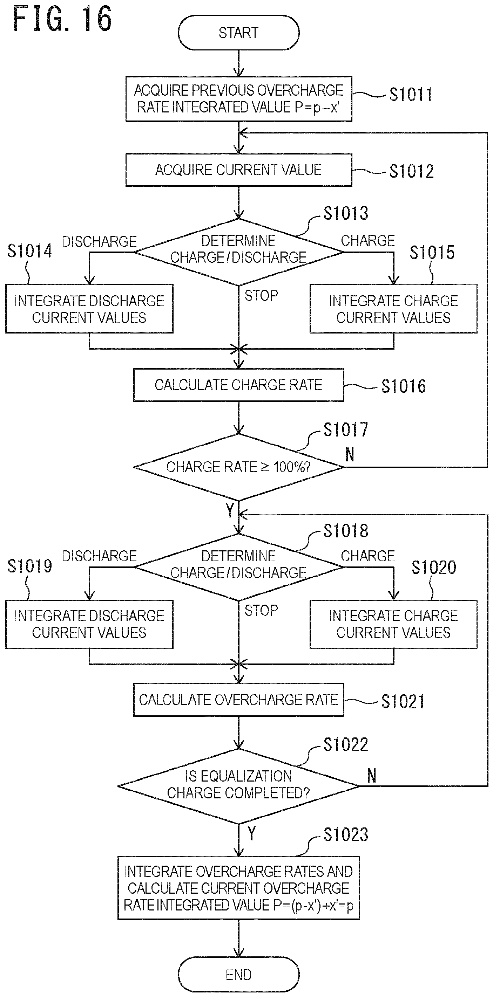

The overcharge rate integrated value calculation unit 231 calculates a current overcharge rate integrated value P (P = (p - x') + x' = p) based on the previous overcharge rate integrated value P (P = p - x') at the time of processing of the previous (n-1-th) equalization charge before the current (n-th) equalization charge. Specific processing in the overcharge rate integrated value calculation unit 231 will be described later with reference to FIG. 16. Information regarding the calculated current overcharge rate integrated value P (P = (p - x') + x' = p) is recorded in a recording unit 12. Here, a charge rate is a value calculated by dividing the total charge amount by the total discharge amount, and as illustrated in FIG. 12, x (%) in a case where the charge rate at the time of processing of the equalization charge exceeds 100% (100 + x)% and the equalization charge E has ended is referred to as an overcharge rate. A value obtained by integrating the overcharge rate x (%) of the first equalization charge E to the overcharge rate x (%) of the n-2-th equalization charge E is the previous overcharge rate integrated value P (P = p - x'). x' is an overcharge rate serving as a determination reference in a case where the equalization charge E is completed at the time of processing of the previous (n-1-th) equalization charge.

In addition, the first current value acquisition unit 232 acquires information regarding a current value of the lead-acid battery B input to the recording unit 12 via the measurement unit 11 from the recording unit 12 from the start to the end of the processing in the state determination unit 13 at the time of the processing of the current (n-th) equalization charge.

In addition, the discharge determination unit 233 determines whether or not the discharge of the lead-acid battery B has started based on the current value of the lead-acid battery B acquired by the first current value acquisition unit 232. Specifically, in a case where the current value of the lead-acid battery B acquired by the first current value acquisition unit 232 is smaller than a first threshold, it is determined that the discharge has started, and in a case where the current value is equal to or larger than the first threshold, it is determined that the lead-acid battery B is in a stop state or a charge state. The first threshold is specifically a negative current value near 0 amperes, and in a case where the current value is smaller than the first threshold, it is determined that the discharge has started, and in a case where the current value is equal to or larger than the first threshold, it is determined that the lead-acid battery B is in the stop state or the charge state. The first threshold for the discharge start determination is set by the setting unit 14 and recorded in the recording unit 12, and the discharge determination unit 233 acquires information regarding the first threshold from the recording unit 12.

In addition, the discharge current integration unit 234 integrates discharge current values after the start of the discharge of the lead-acid battery B, and calculates an integrated discharge capacity value after the start of the discharge of the lead-acid battery B.

The second current value acquisition unit 235 acquires, from the recording unit 12, information regarding the current value of the lead-acid battery B input to the recording unit 12 via the measurement unit 11 from the start to the end of the processing in the state determination unit 13.

In addition, the charge/discharge determination unit 236 determines whether the lead-acid battery B is in a discharge state, the stop state, or the charge state based on the current value of the lead-acid battery B acquired by the second current value acquisition unit 235.

Here, in a case where the current value of the lead-acid battery B acquired by the second current value acquisition unit 235 is smaller than the first threshold (the current value < a first threshold), the charge/discharge determination unit 236 determines that the lead-acid battery B is in the discharge state,

in a case where the first threshold $\leq$ the current value $\leq$ a second threshold, the charge/discharge determination unit 236 determines that the lead-acid battery B is in the stop state, and
in a case where the current value > the second threshold, the charge/discharge determination unit 236 determines that the lead-acid battery B is in the charge state.

The first threshold is the same value as the above-described first threshold, and the second threshold is a positive current value near 0 amperes.

Next, in a case where it is determined by the charge/discharge determination unit 236 that the lead-acid battery B is in the charge state, the capacity turnover value calculation unit 237 calculates the capacity turnover value during operation (hereinafter, referred to as a CT value during operation).

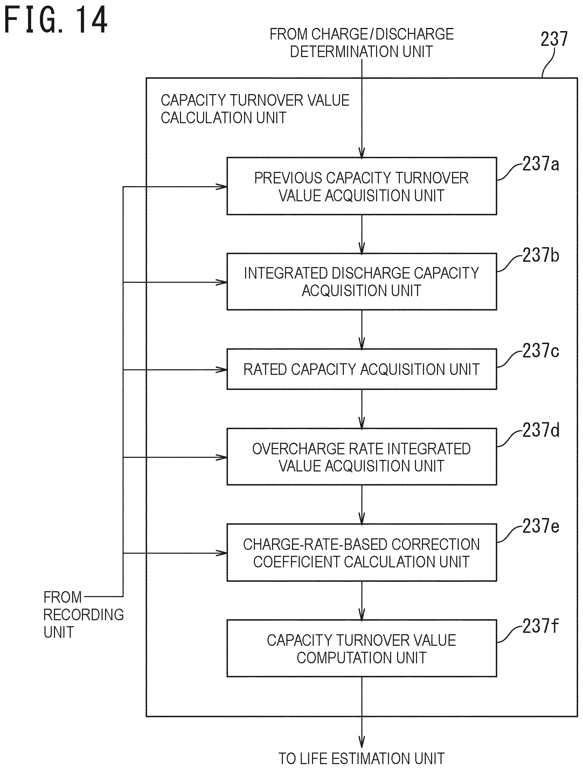

An internal configuration of the capacity turnover value calculation unit 237 will be described in more detail below. FIG. 14 is a block diagram illustrating an internal configuration of the capacity turnover value calculation unit 237 included in the state determination unit 13 illustrated in FIG. 13.

The capacity turnover value calculation unit 237 includes a previous capacity turnover value acquisition unit 237a, an integrated discharge capacity acquisition unit 237b, a rated capacity acquisition unit 237c, an overcharge rate integrated value acquisition unit 237d, a charge-rate-based correction coefficient calculation unit 237e, and a capacity turnover value computation unit 237f.

In a case where it is determined by the charge/discharge determination unit 236 that the lead-acid battery B is in the charge state, the previous capacity turnover value acquisition unit 237a acquires, from the recording unit 12, a capacity turnover value before the start of the processing in the state determination unit 13 (hereinafter, referred to as a previous CT value), at the time of the processing of the current equalization charge. The previous CT value is a CT value during operation calculated by the capacity turnover value calculation unit 237 at the time of the previous processing in the state determination unit 13, and already input from the capacity turnover value calculation unit 237 to the recording unit 12.

In addition, the integrated discharge capacity acquisition unit 237b acquires information regarding the integrated discharge capacity value from the start of the discharge of the lead-acid battery B calculated by the discharge current integration unit 234.

Further, the rated capacity acquisition unit 237c acquires information regarding the rated capacity (Ah) of the lead-acid battery B from the recording unit 12.

In addition, the overcharge rate integrated value acquisition unit 237d acquires information regarding the current overcharge rate integrated value P $(P = (p - x') + x' = p)$ calculated by the overcharge rate integrated value calculation unit 231 from the recording unit 12.

In addition, the charge-rate-based correction coefficient calculation unit 237e calculates the charge-rate-based correction coefficient $K_{CP}$ by the following Formula (3) based on the information regarding the current overcharge rate integrated value P (P = (p - x') + x' = p) acquired by the overcharge rate integrated value acquisition unit 237d.

$$K_{CP} = 1 + P \times b \quad \cdots \quad (3)$$

Here, b is, for example, b = 5.34 × 10$^{-5}$.

Further, the capacity turnover value computation unit 237f calculates the CT value during operation by the following Formula (4) using the previous CT value acquired by the previous capacity turnover value acquisition unit 237a, an integrated discharge capacity from the start of the discharge of the lead-acid battery B acquired by the integrated discharge capacity acquisition unit 237b, the rated capacity (Ah) of the lead-acid battery B acquired by the rated capacity acquisition unit 237c, and the charge-rate-based correction coefficient $K_{CP}$ calculated by the charge-rate-based correction coefficient calculation unit 237e.

CT value during operation = previous CT value + integrated discharge capacity × $K_{CP}$/rated capacity (Ah)　　　　(4)

Then, the life estimation unit 238 of the state determination unit 13 estimates the remaining life of the lead-acid battery B by comparing the CT value from the beginning to the end of life acquired from the recording unit 12 with the CT value during operation calculated by the capacity turnover value calculation unit 237. That is, the life estimation unit 238 estimates the remaining life of the lead-acid battery B from a CT value obtained by subtracting the CT value during operation from the CT value from the beginning to the end of life.

Then, the life estimation unit 238 records an estimation result of the life estimation unit 238 including information regarding the CT value during operation in the recording unit 12.

As described above, in the lead-acid battery system S according to the second embodiment, the capacity turnover value calculation unit 237 calculates the CT value during operation by using the charge-rate-based correction coefficient $K_{CP}$ calculated based on the overcharge rate integrated value of the equalization charge (the current overcharge rate integrated value P (P = (p - x') + x' = p)) calculated by the overcharge rate integrated value calculation unit 231 that calculates the overcharge rate integrated value of the equalization charge E of the lead-acid battery B. As a result, by calculating the CT value during operation in consideration of the overcharge rate integrated value (the current overcharge rate integrated value P (P = (p - x') + x' = p)) of the equalization charge E of the lead-acid battery B, it is possible to consider the progress of the corrosion of the positive electrode and the softening of the active material due to electrolyte loss and to provide the lead-acid battery system S capable of accurately estimating the remaining life of the lead-acid battery B.

In the lead-acid battery system S according to the first embodiment, in a case where the lead-acid battery B is a bipolar lead-acid battery, it is possible to provide the lead-acid battery system S capable of accurately estimating the remaining life of the bipolar lead-acid battery.

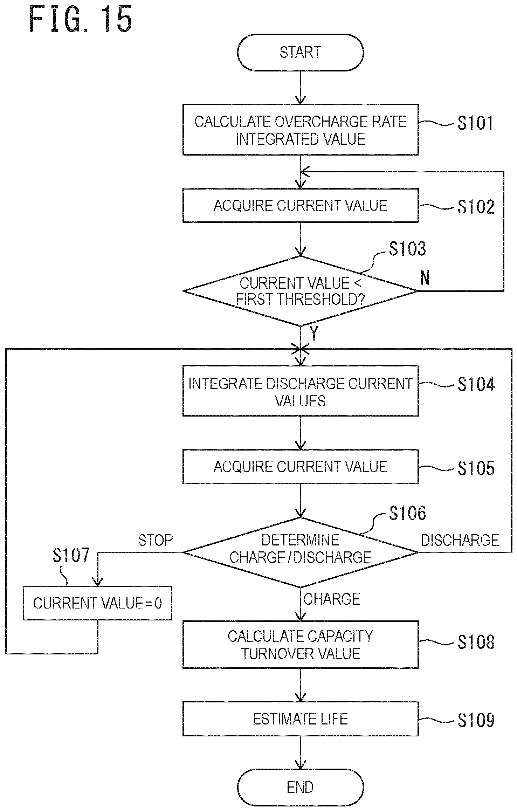

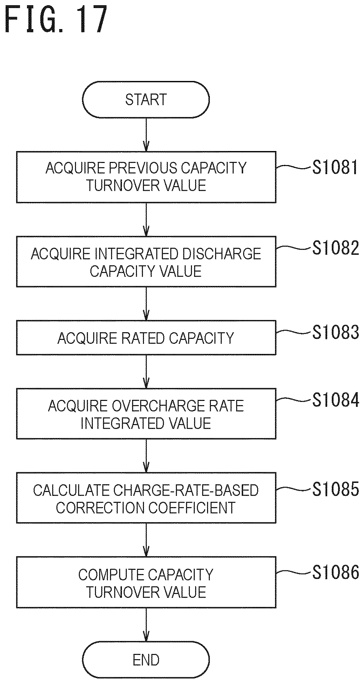

Next, the lead-acid battery life estimation method according to the second embodiment will be described with reference to a flowchart illustrating a flow of processing in the state determination unit illustrated in FIG. 15, a flowchart illustrating a flow of processing of step S101 (overcharge rate integrated value calculation step) in the flowchart of FIG. 15 illustrated in FIG. 16, and a flowchart illustrating a flow of processing of step S108 (capacity turnover value calculation step) in the flowchart of FIG. 15 illustrated in FIG. 17.

The processing in the state determination unit 13 is executed for each time the equalization charge E is performed. Step S101 (overcharge rate integrated value calculation step) illustrated in FIG. 15 is executed at the time of the processing of the previous (n-1-th) equalization charge before the current (n-th) equalization charge. At the time of the processing of the current (n-th) equalization charge, steps S102 (current value acquisition step) to S109 (life estimation step) illustrated in FIG. 15 are executed for each of the discharges D1 to D5, and the remaining life of the lead-acid battery B is estimated by comparing the capacity turnover value from the beginning to the end of life and the capacity turnover value during operation.

First, in step S101, the overcharge rate integrated value calculation unit 231 of the state determination unit 13 calculates the current overcharge rate integrated value P (P = (p - x') + x' = p) based on the previous overcharge rate integrated value P (P = p - x') at the time of the processing of the previous (n-1-th) equalization charge before the current (n-th) equalization charge (overcharge rate integrated value calculation step).

Details of the processing of step S101 in the overcharge rate integrated value calculation unit 231 will be described with reference to FIG. 16.

First, in step S1011, the overcharge rate integrated value calculation unit 231 acquires information regarding the previous overcharge rate integrated value P (P = p - x') from the recording unit 12. A value obtained by integrating the overcharge rate x (%) of the first equalization charge E to the overcharge rate x (%) of the n-2-th equalization charge E is the previous overcharge rate integrated value P (P = p - x').

Next, in step S1012, the overcharge rate integrated value calculation unit 231 acquires, from the recording unit 12, information regarding the current value of the lead-acid battery B input to the recording unit 12 via the measurement unit 11.

Next, in step S1013, the overcharge rate integrated value calculation unit 231 determines whether the lead-acid battery B is in the discharge state, the stop state, or the charge state based on the current value of the lead-acid battery B acquired in step S1012.

Here, in a case where the current value of the lead-acid battery B acquired in step S1012 is smaller than the first threshold (the current value < the first threshold), the overcharge rate integrated value calculation unit 231 determines that the lead-acid battery B is in the discharge state,

in a case where the first threshold ≤ the current value ≤ the second threshold, overcharge rate integrated value calculation unit 231 determines that the lead-acid battery B is in the stop state, and
in a case where the current value > the second threshold, the overcharge rate integrated value calculation unit 231 determines that the lead-acid battery B is in the charge state.

The first threshold is a negative current value near 0 amperes, and the second threshold is a positive current value near 0 amperes.

Then, in a case where it is determined that the lead-acid battery B is in the discharge state, the processing proceeds to step S1014, in a case where it is determined that the lead-acid battery B is in the charge state, the processing proceeds to step S1015, and in a case where it is determined that the lead-acid battery B is in the stop state, the processing proceeds to step S1016.

Then, in step S1014, the overcharge rate integrated value calculation unit 231 integrates the discharge current values from the start of the discharge of the lead-acid battery B acquired in step S1012, and calculates the integrated discharge capacity value from the start of the discharge of the lead-acid battery B.

In step S1015, the overcharge rate integrated value calculation unit 231 integrates charge current values from the start of the charge of the lead-acid battery B acquired in step S1012, and calculates an integrated charge capacity value from the start of the charge of the lead-acid battery B.

In step S1016, the overcharge rate integrated value calculation unit 231 calculates the charge rate based on the integrated discharge capacity value calculated in step S1014 and the integrated charge capacity value calculated in step S1015. Here, the charge rate is calculated by dividing the total charge amount by the total discharge amount.

Next, in step S1017, the overcharge rate integrated value calculation unit 231 determines whether or not the charge rate calculated in step S1016 is equal to or more than 100%.

Then, in a case where it is determined that the charge rate is equal to or more than 100%, the processing proceeds to step S1018, and in a case where it is determined that the charge rate is less than 100%, the processing returns to step S1012.

Then, in step S1018, the overcharge rate integrated value calculation unit 231 determines whether the lead-acid battery B is in the discharge state, the stop state, or the charge state based on the current value of the lead-acid battery B acquired in step S1012.

Here, in a case where the current value of the lead-acid battery B acquired in step S1012 is smaller than the first threshold (the current value < the first threshold), the overcharge rate integrated value calculation unit 231 determines that the lead-acid battery B is in the discharge state,

in a case where the first threshold ≤ the current value ≤ the second threshold, overcharge rate integrated value calculation unit 231 determines that the lead-acid battery B is in the stop state, and
in a case where the current value > the second threshold, the overcharge rate integrated value calculation unit 231 determines that the lead-acid battery B is in the charge state.

The first threshold is a negative current value near 0 amperes, and the second threshold is a positive current value near 0 amperes.

Then, in a case where it is determined that the lead-acid battery B is in the discharge state, the processing proceeds to step S1019, in a case where it is determined that the lead-acid battery B is in the charge state, the processing proceeds to step S1020, and in a case where it is determined that the lead-acid battery B is in the stop state, the processing proceeds to step S1021.

Then, in step S1019, the overcharge rate integrated value calculation unit 231 integrates the discharge current values from the start of the discharge of the lead-acid battery B acquired in step S1012, and calculates the integrated discharge capacity value from the start of the discharge of the lead-acid battery B.

In step S1020, the overcharge rate integrated value calculation unit 231 integrates charge current values from the start of the charge of the lead-acid battery B acquired in step S1012, and calculates an integrated charge capacity value from the start of the charge of the lead-acid battery B.

In step S1021, the overcharge rate integrated value calculation unit 231 calculates the overcharge rate based on the integrated discharge capacity value calculated in step S1019 and the integrated charge capacity value calculated in step S1020. Here, the overcharge rate is a charge rate after the charge rate exceeds 100%.

Next, in step S1022, the overcharge rate integrated value calculation unit 231 determines whether or not the equalization charge E is completed.

Specifically, it is determined whether or not the overcharge rate calculated in step S1021 has reached the overcharge rate x' serving as the determination reference in a case where the equalization charge E is completed. In a case where the overcharge rate has reached the overcharge rate x' serving as the determination reference in a case where the equalization charge E is completed, the processing proceeds to step S1023. In a case where the overcharge rate has not reached the overcharge rate x', the processing returns to step S1018.

Next, in step S1023, the overcharge rate integrated value calculation unit 231 integrates the overcharge rate x' with the previous overcharge rate integrated value $P = p - x'$ acquired in step S1011, and calculates the current overcharge rate integrated value $P$ ($P = (p - x') + x' = p$).

Information regarding the calculated current overcharge rate integrated value $P$ ($P = (p - x') + x' = p$) is recorded in the recording unit 12.

As a result, the processing of step S101 in the overcharge rate integrated value calculation unit 231 ends.

Next, in step S102, the first current value acquisition unit 232 of the state determination unit 13 acquires, from the recording unit 12, information regarding the current value of the lead-acid battery B input to the recording unit 12 via the measurement unit 11 from the start to the end of the processing in the state determination unit 13 at the time of the processing of the current (n-th) equalization charge (first current value acquisition step).

Next, in step S103, the discharge determination unit 233 of the state determination unit 13 determines whether or not the discharge of the lead-acid battery B has started based on the current value of the lead-acid battery B acquired in step S102 (discharge determination step). Specifically, in a case where the current value of the lead-acid battery B acquired in step S102 is smaller than the first threshold, it is determined that the discharge has started, and in a case where the current value is equal to or larger than the first threshold, it is determined that the lead-acid battery B is in the stop state or the charge state. The first threshold is specifically a negative current value near 0 amperes, and in a case where the current value is smaller than the first threshold, it is determined that the discharge has started, and in a case where the current value is equal to or larger than the first threshold, it is determined that the lead-acid battery B is in the stop state or the charge state.

Next, in step S104, the discharge current integration unit 234 of the state determination unit 13 integrates the discharge current values from the start of the discharge of the lead-acid battery B, and calculates the integrated discharge capacity value from the start of the discharge of the lead-acid battery B (integrated discharge capacity value calculation step).

Next, in step S105, the second current value acquisition unit 235 of the state determination unit 13 acquires, from the recording unit 12, information regarding the current value of the lead-acid battery B input to the recording unit 12 via the measurement unit 11 from the start to the end of the processing in the state determination unit 13 (second current value acquisition step).

Next, in step S106, the charge/discharge determination unit 236 of the state determination unit 13 determines whether the lead-acid battery B is in the discharge state, the stop state, or the charge state based on the current value of the lead-acid battery B acquired in step S105 (charge/discharge determination step).

Here, in a case where the current value of the lead-acid battery B acquired in step S105 is smaller than the first threshold (the current value < a first threshold), the charge/discharge determination unit 236 determines that the lead-acid battery B is in the discharge state,

in a case where the first threshold ≤ the current value ≤ a second threshold, the charge/discharge determination unit 236 determines that the lead-acid battery B is in the stop state, and
in a case where the current value > the second threshold, the charge/discharge determination unit 236 determines that the lead-acid battery B is in the charge state.

The first threshold is the same value as the above-described first threshold, and the second threshold is a positive current value near 0 amperes.

In a case where it is determined that the lead-acid battery B is in the discharge state, the processing returns to step S104. In a case where it is determined that the lead-acid battery B is in the stop state, the processing proceeds to step S107. In a case where it is determined that the lead-acid battery B is in the charge state, the processing proceeds to step S108.

In step S107, the current value is set to 0 assuming that the lead-acid battery B is in the stop state, and the processing returns to step S104.

In step S108, the capacity turnover value calculation unit 237 of the state determination unit 13 calculates the capacity turnover value during operation (hereinafter, referred to as the CT value during operation) (capacity turnover value calculation step).

A detailed flow of the processing of step S108 in the capacity turnover value calculation unit 237 will be described with reference to FIG. 17.

First, in step S1081, the previous capacity turnover value acquisition unit 237a of the capacity turnover value calculation unit 237 acquires, from the recording unit 12, the capacity turnover value before the start of the processing in the state determination unit 13 (hereinafter, referred to as the previous CT value) in the processing of the current (n-th) equalization charge (previous capacity turnover value acquisition step). The previous CT value is a CT value during operation calculated by the capacity turnover value calculation unit 237 at the time of the previous processing in the state determination unit 13, and already input from the capacity turnover value calculation unit 237 to the recording unit 12.

Next, in step 10S82, the integrated discharge capacity acquisition unit 237b of the capacity turnover value calculation unit 237 acquires information regarding the integrated discharge capacity value from the start of the discharge of the lead-acid battery B calculated in step S104 (integrated discharge capacity value acquisition step).

Next, in step S1083, the rated capacity acquisition unit 237c of the capacity turnover value calculation unit 237 acquires information regarding the rated capacity (Ah) of the lead-acid battery B from the recording unit 12.

Next, in step S1084, the overcharge rate integrated value acquisition unit 237d of the capacity turnover value calculation unit 237 acquires information regarding the current overcharge rate integrated value $P$ ($P = (p - x') + x' = p$) calculated in step S101 from the recording unit 12 (overcharge rate integrated value acquisition step).

Next, in step S1085, the charge-rate-based correction coefficient calculation unit 237e of the capacity turnover value calculation unit 237 calculates the charge-rate-based correction coefficient $K_{CP}$ by Formula (3) described above based on the information regarding the current overcharge rate integrated value $P$ ($P = (p - x') + x' = p$) acquired in step S1084 (correction coefficient based on charge rate calculation step).

Next, in step S1086, the capacity turnover value computation unit 237f of the capacity turnover value calculation unit 237 calculates the CT value during operation by Formula (4) described above using the previous CT value acquired in step S1081, the integrated discharge capacity from the start of the discharge of the lead-acid battery B acquired in step S1082, the rated capacity (Ah) of the lead-acid battery B acquired in step S1083, and the charge-rate-based correction coefficient $K_{CP}$ calculated in step S1085 (capacity turnover value computation step).

As a result, the processing of step S108 in the capacity turnover value calculation unit 137 ends.

In step S109, the life estimation unit 238 of the state determination unit 13 estimates the remaining life of the lead-acid battery B by comparing the CT value from the beginning to the end of life acquired from the recording unit 12 with the CT value during operation calculated in step S108 (life estimation step). That is, the life estimation unit 238 estimates the remaining life of the lead-acid battery B from a CT value obtained by subtracting the CT value during operation from the CT value from the beginning to the end of life.

Then, the life estimation unit 238 records an estimation result of the life estimation unit 238 including information regarding the CT value during operation in the recording unit 12.

As described above, in the lead-acid battery life estimation method according to the second embodiment, in the capacity turnover value calculation step (step S108), the CT value during operation is calculated using the charge-rate-based correction coefficient $K_{CP}$ calculated based on the overcharge rate integrated value of the equalization charge (the current overcharge rate integrated value $P$ ($P = (p - x') + x' = p$)) calculated in the overcharge rate integrated value calculation step (step S101) of calculating the overcharge rate integrated value of the equalization charge E of the lead-acid battery B. As a result, by calculating the CT value during operation in consideration of the overcharge rate integrated value (the current overcharge rate integrated value $P$ ($P = (p - x') + x' = p$)) of the equalization charge E of the lead-acid battery B, it is possible to consider the progress of the corrosion of the positive electrode and the softening of the active material due to electrolyte loss and to provide the lead-acid battery life estimation method capable of accurately estimating the remaining life of the lead-acid battery B.

In the lead-acid battery life estimation method according to the second embodiment, in a case where the lead-acid battery B is a bipolar lead-acid battery, it is possible to provide a lead-acid battery life estimation method capable of accurately estimating the remaining life of the bipolar lead-acid battery.

Although the embodiments of the present invention have been described above, the present invention is not limited thereto, and various modifications and improvements can be made therein.

For example, in the lead-acid battery system S and the lead-acid battery life estimation method according to the first embodiment, the equalization-charge-number-based correction coefficient $K_{CN}$ is calculated by Formula (1), but the equalization-charge-number-based correction coefficient $K_{CN}$ does not have to be necessarily based on Formula (1) as long as the equalization-charge-number-based correction coefficient $K_{CN}$ is calculated using the number of equalization charges E.

In the lead-acid battery system S and the lead-acid battery life estimation method according to the first embodiment, the charge-rate-based correction coefficient $K_{CP}$ is calculated by Formula (3), but the charge-rate-based correction coefficient $K_{CP}$ does not have to be necessarily based on Formula (3) as long as the charge-rate-based correction coefficient $K_{CP}$ is calculated using the overcharge rate integrated value of the equalization charge.

Industrial Applicability

The lead-acid battery system and the lead-acid battery life estimation method according to the present invention can accurately estimate a remaining life of a lead-acid battery by calculating a capacity turnover value during operation in consideration of the number of equalization charges of the lead-acid battery or an overcharge rate integrated value of the equalization charge of the lead-acid battery, and thus can be extremely advantageously used in various industries.

Reference Signs List

1 BMU
2 EMS
3 PCS
11 Measurement unit
12 Recording unit
13 State determination unit
14 Setting unit
15 Communication unit
131 Equalization charge number calculation unit
132 First current value acquisition unit
133 Discharge determination unit
134 Discharge current integration unit
135 Second current value acquisition unit
136 Charge/discharge determination unit
137 Capacity turnover value calculation unit
137a Previous capacity turnover value acquisition unit
137b Integrated discharge capacity acquisition unit
137c Rated capacity acquisition unit
137d Equalization charge number acquisition unit
137e Equalization-charge-number-based correction coefficient calculation unit
137f Capacity turnover value computation unit
138 Life estimation unit
231 Overcharge rate integrated value calculation unit
232 First current value acquisition unit
233 Discharge determination unit
234 Discharge current integration unit
235 Second current value acquisition unit
236 Charge/discharge determination unit
237 Capacity turnover value calculation unit
237a Previous capacity turnover value acquisition unit
237b Integrated discharge capacity acquisition unit
237c Rated capacity acquisition unit
237d Overcharge rate integrated value acquisition unit
237e Charge-rate-based correction coefficient calculation unit
237f Capacity turnover value computation unit
238 Life estimation unit
B Lead-acid battery
S Lead-acid battery system

**Claims**

**1.**    A lead-acid battery system configured to estimate a remaining life of a lead-acid battery by comparing a capacity turnover value from a beginning to an end of life with a capacity turnover value during operation, the lead-acid battery system comprising:

a capacity turnover value calculation unit configured to calculate the capacity turnover value during operation, wherein the capacity turnover value calculation unit calculates the capacity turnover value during operation by using an equalization-charge-number-based correction coefficient calculated based on the number of equalization charges calculated by an equalization charge number calculation unit configured to calculate the number of equalization charges of the lead-acid battery, or a charge-rate-based correction coefficient calculated based on an overcharge rate integrated value of the equalization charge calculated by an overcharge rate integrated value calculation unit configured to calculate the overcharge rate integrated value of the equalization charge of the lead-acid battery.

2. The lead-acid battery system according to claim 1, wherein in a case where the equalization charge of the lead-acid battery is interrupted in a middle, the equalization charge number calculation unit calculates the number of equalization charges based on a constant voltage (CV) charge time from when a CV charge, which is charging at a constant voltage, starts to when the equalization charge is interrupted and a CV time for equalization charge completion determination, and the capacity turnover value calculation unit calculates the equalization-charge-number-based correction coefficient based on the number of equalization charges calculated by the equalization charge number calculation unit.

3. The lead-acid battery system according to claim 1, wherein in a case where the equalization charge of the lead-acid battery is interrupted in a middle, the equalization charge number calculation unit calculates the number of equalization charges based on a charge rate when the equalization charge is interrupted and a charge rate for the equalization charge completion determination, and the capacity turnover value calculation unit calculates the equalization-charge-number-based correction coefficient based on the number of equalization charges calculated by the equalization charge number calculation unit.

4. The lead-acid battery system according to any one of claims 1 to 3, wherein the lead-acid battery is a bipolar lead-acid battery.

5. A lead-acid battery life estimation method in which a remaining life of a lead-acid battery is estimated by comparing a capacity turnover value from a beginning to an end of life and a capacity turnover value during operation, the lead-acid battery life estimation method comprising:

a capacity turnover value calculation step of calculating the capacity turnover value during operation, wherein in the capacity turnover value calculation step, the capacity turnover value during operation is calculated using an equalization-charge-number-based correction coefficient calculated based on the number of equalization charges calculated in an equalization charge number calculation step of calculating the number of equalization charges of the lead-acid battery, or a charge-rate-based correction coefficient calculated based on an overcharge rate integrated value of the equalization charge calculated in an overcharge rate integrated value calculation step of calculating the overcharge rate integrated value of the equalization charge of the lead-acid battery.

6. The lead-acid battery life estimation method according to claim 5, wherein in the equalization charge number calculation step, in a case where the equalization charge of the lead-acid battery is interrupted in a middle, the number of equalization charges is calculated based on a constant voltage (CV) charge time from when a CV charge, which is charging at a constant voltage, starts to when the equalization charge is interrupted and a CV time for equalization charge completion determination, and in the capacity turnover value calculation step, the equalization-charge-number-based correction coefficient is calculated based on the number of equalization charges calculated in the equalization charge number calculation step.

7. The lead-acid battery life estimation method according to claim 5, wherein in the equalization charge number calculation step, in a case where the equalization charge of the lead-acid battery is interrupted in a middle, the number of equalization charges is calculated based on a charge rate when the equalization charge is interrupted and a charge rate for the equalization charge completion determination, and in the capacity turnover value calculation step, the equalization-charge-number-based correction coefficient is calculated based on the number of equalization charges calculated in the equalization charge number calculation step.

8. The lead-acid battery life estimation method according to any one of claims 5 to 7, wherein the lead-acid battery is a bipolar lead-acid battery.

FIG. 1

GRID CURRENT

_S_

3

LOAD —— PCS ←—————— EMS 2

B

LEAD-ACID
BATTERY ←——————→ BMU 1

FIG. 2

1

12                          11

RECORDING
UNIT ←—— MEASUREMENT
UNIT

15

COMMUNICATION
UNIT ←——————————→

13                          14

STATE
DETERMINATION
UNIT

SETTING UNIT

# FIG. 3

NUMBER N OF EQUALIZATION CHARGES

| N=n−1 | N=n | N=n+1 |
|---|---|---|

FIG. 4

EP 4 474 840 A1

# FIG. 5

NUMBER N OF EQUALIZATION CHARGES

| N=n−1 | N=n | N=n+1 |
|---|---|---|

| N=n−1 | N=n | $N=n+\dfrac{\alpha}{A}$ |
|---|---|---|

CV TIME FOR EQUALIZATION CHARGE COMPLETION DETERMINATION=Ah

CV CHARGE TIME BEFORE EQUALIZATION CHARGE IS INTERRUPTED=αh

CURRENT

E   C1   C2   C3   C4   E

0 → TIME

D1   D2   D3   D4   D5

INTERRUPTED   COMPLETED

FIG. 6

FROM CHARGE/DISCHARGE
DETERMINATION UNIT

137

CAPACITY TURNOVER VALUE
CALCULATION UNIT

PREVIOUS CAPACITY TURNOVER
VALUE ACQUISITION UNIT
137a

INTEGRATED DISCHARGE CAPACITY
ACQUISITION UNIT
137b

RATED CAPACITY ACQUISITION UNIT
137c

EQUALIZATION CHARGE NUMBER
ACQUISITION UNIT
137d

EQUALIZATION-CHARGE-NUMBER-BASED
CORRECTION COEFFICIENT CALCULATION UNIT
137e

CAPACITY TURNOVER VALUE
COMPUTATION UNIT
137f

FROM
RECORDING
UNIT

TO LIFE ESTIMATION UNIT

FIG. 7

```
                    ┌──────────────┐
                    │    START     │
                    └──────┬───────┘
                           │
                    ┌──────▼─────────────┐
                    │ CALCULATE NUMBER OF │───S1
                    │ EQUALIZATION CHARGES│
                    └──────┬─────────────┘
                           │
                    ┌──────▼─────────────┐
                    │ ACQUIRE CURRENT VALUE│───S2
                    └──────┬─────────────┘
                           │
                          ╱ ╲              S3
                         ╱   ╲
                        ╱ CURRENT ╲    N
                        ╲ VALUE    ╱──────
                        ╲ < FIRST ╱
                         ╲THRESHOLD╱
                          ╲ ╱  Y
                           │
                    ┌──────▼─────────────┐
                    │ INTEGRATE DISCHARGE │───S4
                    │ CURRENT VALUES      │
                    └──────┬─────────────┘
                           │
                    ┌──────▼─────────────┐
                    │ ACQUIRE CURRENT VALUE│───S5
                    └──────┬─────────────┘
                           │
                          ╱ ╲              S6
        STOP             ╱   ╲        DISCHARGE
     ┌───────────────── DETERMINE ───────────
     │               ╲CHARGE/DISCHARGE╱
     │                 ╲   ╱
  ┌──▼────────┐         ╲ ╱ CHARGE
  │CURRENT    │ S7       │
  │VALUE = 0  │   ┌──────▼─────────────┐
  └───────────┘   │ CALCULATE CAPACITY  │───S8
     │            │ TURNOVER VALUE      │
     │            └──────┬─────────────┘
     │                   │
     │            ┌──────▼─────────────┐
     │            │ ESTIMATE LIFE       │───S9
     │            └──────┬─────────────┘
     │                   │
     │            ┌──────▼───────┐
     │            │    END       │
     │            └──────────────┘
```

FIG. 8

START

ACQUIRE PREVIOUS NUMBER OF EQUALIZATION CHARGES N=n-1 —— S11a

ACQUIRE CURRENT VALUE —— S12a

S13a
DETERMINE CHARGE/DISCHARGE

S14a DISCHARGE · CHARGE · S15a
STOP

INTEGRATE DISCHARGE CURRENT VALUES

INTEGRATE CHARGE CURRENT VALUES

CALCULATE CHARGE RATE —— S16a

S17a
CHARGE RATE ≥ CV CHARGE DETERMINATION THRESHOLD (NORMALLY 100%)? — N

Y

CALCULATE CV CHARGE TIME —— S18a

S19a
CV CHARGE TIME = CV TIME A FOR EQUALIZATION CHARGE COMPLETION DETERMINATION? — N

S21a
END EQUALIZATION CHARGE BASED ON CV CHARGE TIME α BEFORE EQUALIZATION CHARGE IS INTERRUPTED? — N

Y

Y

CALCULATE CURRENT NUMBER OF EQUALIZATION CHARGES N =(n-1)+1=n — S20a

CALCULATE CURRENT NUMBER OF EQUALIZATION CHARGES N =(n-1)+α/A — S22a

END

# FIG. 9

START

↓

ACQUIRE PREVIOUS CAPACITY TURNOVER VALUE — S81

↓

ACQUIRE INTEGRATED DISCHARGE CAPACITY VALUE — S82

↓

ACQUIRE RATED CAPACITY — S83

↓

CALCULATE NUMBER OF EQUALIZATION CHARGES — S84

↓

CALCULATE EQUALIZATION-CHARGE-NUMBER-BASED CORRECTION COEFFICIENT — S85

↓

COMPUTE CAPACITY TURNOVER VALUE — S86

↓

END

# FIG. 10

INTERRUPTED COMPLETED

CURRENT

E    C1    C2    C3    C4    E

0                                                TIME

D1    D2    D3    D4    D5

CHARGE RATE WHEN EQUALIZATION CHARGE IS INTERRUPTED=$\beta$%

CHARGE RATE FOR EQUALIZATION CHARGE COMPLETION DETERMINATION=B%

| N=n-1 | N=n | $N=n+\dfrac{\beta-100}{B-100}$ |
|---|---|---|

| N=n-1 | N=n | N=n+1 |
|---|---|---|

NUMBER N OF EQUALIZATION CHARGES

FIG. 11

START

ACQUIRE PREVIOUS NUMBER OF
EQUALIZATION CHARGES N=n-1 — S11b

ACQUIRE CURRENT VALUE — S12b

S13b
DETERMINE
CHARGE/DISCHARGE

S14b DISCHARGE          CHARGE  S15b

INTEGRATE DISCHARGE     STOP     INTEGRATE CHARGE
CURRENT VALUES                   CURRENT VALUES

CALCULATE CHARGE RATE — S16b

S17b
CHARGE RATE ≥ 100%?   N

Y

S18b
DETERMINE
CHARGE/DISCHARGE

S19b DISCHARGE          CHARGE  S20b

INTEGRATE DISCHARGE     STOP     INTEGRATE CHARGE
CURRENT VALUES                   CURRENT VALUES

S21b — CALCULATE CHARGE RATE

S22b
CHARGE RATE
= CHARGE RATE B
FOR EQUALIZATION CHARGE     N
DETERMINATION
COMPLETION?

S24b
END
EQUALIZATION
CHARGE BASED ON
CHARGE RATE β WHEN EQUALIZATION     N
CHARGE IS
INTERRUPTED?

Y — S23b

CALCULATE CURRENT NUMBER OF
EQUALIZATION CHARGES N=(n-1)+1=n

Y — S25b

CALCULATE CURRENT NUMBER OF
EQUALIZATION CHARGES N=
(n-1)+β-100/B-100

END

# FIG. 12

| P=p−x' | P=p | P=p+x |
|---|---|---|
| n−1 | n | n+1 |

**FIG. 13**

1

BMU

13

STATE DETERMINATION UNIT

12

231
OVERCHARGE RATE INTEGRATED VALUE CALCULATION UNIT

236
CHARGE / DISCHARGE DETERMINATION UNIT

232
FIRST CURRENT VALUE ACQUISITION UNIT

237
CAPACITY TURNOVER VALUE CALCULATION UNIT

233
DISCHARGE DETERMINATION UNIT

RECORDING UNIT

234
DISCHARGE CURRENT INTEGRATION UNIT

238
LIFE ESTIMATION UNIT

235
SECOND CURRENT VALUE ACQUISITION UNIT

# FIG. 14

FROM CHARGE/DISCHARGE
DETERMINATION UNIT

237

CAPACITY TURNOVER VALUE
CALCULATION UNIT

PREVIOUS CAPACITY TURNOVER
VALUE ACQUISITION UNIT — 237a

INTEGRATED DISCHARGE CAPACITY
ACQUISITION UNIT — 237b

RATED CAPACITY ACQUISITION UNIT — 237c

OVERCHARGE RATE INTEGRATED
VALUE ACQUISITION UNIT — 237d

CHARGE-RATE-BASED CORRECTION
COEFFICIENT CALCULATION UNIT — 237e

FROM
RECORDING
UNIT

CAPACITY TURNOVER VALUE
COMPUTATION UNIT — 237f

TO LIFE ESTIMATION UNIT

# FIG. 15

START

CALCULATE OVERCHARGE RATE INTEGRATED VALUE ── S101

ACQUIRE CURRENT VALUE ── S102

CURRENT VALUE < FIRST THRESHOLD? ── S103

N

Y

INTEGRATE DISCHARGE CURRENT VALUES ── S104

ACQUIRE CURRENT VALUE ── S105

DETERMINE CHARGE/DISCHARGE ── S106

STOP

DISCHARGE

S107

CURRENT VALUE = 0

CHARGE

CALCULATE CAPACITY TURNOVER VALUE ── S108

ESTIMATE LIFE ── S109

END

# FIG. 16

```
                        ┌─────────────┐
                        │    START    │
                        └─────────────┘
                               │
                               ▼
          ┌──────────────────────────────────────┐
          │  ACQUIRE PREVIOUS OVERCHARGE          │──── S1011
          │  RATE INTEGRATED VALUE P = p−x'       │
          └──────────────────────────────────────┘
                               │
                               ▼
          ┌──────────────────────────────────────┐
          │      ACQUIRE CURRENT VALUE            │──── S1012
          └──────────────────────────────────────┘
                               │
                               ▼            S1013
      DISCHARGE    ◇─────────────────────────◇    CHARGE
  S1014    ┌───────│  DETERMINE              │────────┐  S1015
           │       │  CHARGE / DISCHARGE     │        │
           ▼       ◇─────────────────────────◇        ▼
  ┌──────────────────┐       STOP        ┌──────────────────┐
  │ INTEGRATE DISCHARGE│                 │ INTEGRATE CHARGE │
  │ CURRENT VALUES    │                  │ CURRENT VALUES   │
  └──────────────────┘                   └──────────────────┘
           │                  │                    │
           └──────────────────┼────────────────────┘
                              ▼
          ┌──────────────────────────────────────┐
          │     CALCULATE CHARGE RATE             │──── S1016
          └──────────────────────────────────────┘
                              │
                              ▼           S1017
                 ◇───────────────────────◇     N
                 │  CHARGE RATE ≥ 100%?   │─────────→
                 ◇───────────────────────◇
                              │ Y
                              ▼           S1018
      DISCHARGE    ◇─────────────────────────◇    CHARGE
  S1019    ┌───────│  DETERMINE              │────────┐  S1020
           │       │  CHARGE / DISCHARGE     │        │
           ▼       ◇─────────────────────────◇        ▼
  ┌──────────────────┐       STOP        ┌──────────────────┐
  │ INTEGRATE DISCHARGE│                 │ INTEGRATE CHARGE │
  │ CURRENT VALUES    │                  │ CURRENT VALUES   │
  └──────────────────┘                   └──────────────────┘
           │                  │                    │
           └──────────────────┼────────────────────┘
                              ▼
          ┌──────────────────────────────────────┐
          │   CALCULATE OVERCHARGE RATE           │──── S1021
          └──────────────────────────────────────┘
                              │
                              ▼           S1022
                 ◇───────────────────────◇     N
                 │  IS EQUALIZATION       │─────────→
                 │  CHARGE COMPLETED?     │
                 ◇───────────────────────◇
                              │ Y        S1023
                              ▼
          ┌──────────────────────────────────────┐
          │ INTEGRATE OVERCHARGE RATES AND        │
          │ CALCULATE CURRENT OVERCHARGE          │
          │ RATE INTEGRATED VALUE P=(p-x')+x'=p   │
          └──────────────────────────────────────┘
                              │
                              ▼
                        ┌─────────────┐
                        │     END     │
                        └─────────────┘
```

# FIG. 17

START

ACQUIRE PREVIOUS CAPACITY
TURNOVER VALUE — S1081

ACQUIRE INTEGRATED DISCHARGE
CAPACITY VALUE — S1082

ACQUIRE RATED CAPACITY — S1083

ACQUIRE OVERCHARGE RATE
INTEGRATED VALUE — S1084

CALCULATE CHARGE-RATE-BASED
CORRECTION COEFFICIENT — S1085

COMPUTE CAPACITY
TURNOVER VALUE — S1086

END

# FIG. 18

FIG. 18 graph: DISCHARGE VOLTAGE [V] vs NUMBER OF CYCLES. TEST PERIOD : 4.5 YEARS. TEST RESULT. TEST CONDITIONS — TEMPERATURE : 25°C, DISCHARGE : 0.23×2.3hn, CHARGE : 2.45V,104%. DEADLINE. SPECIFICATION : 4200 CYCLES, 4500 CYCLES.

# FIG. 19

FIG. 19 graph: LIFE [CYCLE] vs DOD [%]. AMBIENT TEMPERATURE : 25°C. X.

# FIG. 20

## INTERNATIONAL SEARCH REPORT

| International application No. |
|---|
| **PCT/JP2023/002258** |

### A. CLASSIFICATION OF SUBJECT MATTER

***G01R 31/392***(2019.01)i; ***G01R 31/379***(2019.01)i; ***G01R 31/3828***(2019.01)i; ***H01M 10/48***(2006.01)i; ***H02J 7/00***(2006.01)i
FI: G01R31/392; G01R31/379; G01R31/3828; H01M10/48 P; H02J7/00 Y

According to International Patent Classification (IPC) or to both national classification and IPC

### B. FIELDS SEARCHED

Minimum documentation searched (classification system followed by classification symbols)

G01R31/392; G01R31/379; G01R31/3828; H01M10/48; H02J7/00

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | JP 2003-161768 A (NTT POWER & BUILDING FACILITIES INC.) 06 June 2003 (2003-06-06) | 1-8 |
| A | JP 2008-74257 A (MAZDA MOTOR CORP.) 03 April 2008 (2008-04-03) | 1-8 |
| A | JP 6430054 B1 (THE FURUKAWA BATTERY CO., LTD.) 28 November 2018 (2018-11-28) | 1-8 |
| A | WO 2010/001605 A1 (PANASONIC CORP.) 07 January 2010 (2010-01-07) | 1-8 |
| A | WO 2013/054672 A1 (SHIN-KOBE ELECTRIC MACHINERY CO., LTD.) 18 April 2013 (2013-04-18) | 1-8 |
| A | WO 2010/079745 A1 (SHIN-KOBE ELECTRIC MACHINERY CO., LTD.) 15 July 2010 (2010-07-15) | 1-8 |
| A | CN 103529399 A (HUNAN UNIVERSITY) 22 January 2014 (2014-01-22) | 1-8 |
| A | CN 112290637 A (ELECTRIC POWER RESEARCH INSTITUTE OF STATE GRID LIAONING ELECTRIC POWER SUPPLY CO., LTD.) 29 January 2021 (2021-01-29) | 1-8 |

☑ Further documents are listed in the continuation of Box C.　　☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **17 March 2023** | **04 April 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**

| International application No. |
|---|
| **PCT/JP2023/002258** |

**C.  DOCUMENTS CONSIDERED TO BE RELEVANT**

| Category* | Citation of document, with indication, where appropriate, of the relevant passages | Relevant to claim No. |
|---|---|---|
| A | 中村秀人; 可知純夫; 渡部大介; 久保山浩稔; 有馬康弘; 三浦優, 蓄電池状態監視装置 (BMU)の開発, 古河電工時報, February 2013, no. 131, pages 16-20, available at internet <URL:https://www.furukawa.co.jp/jiho/fj131/fj131_03.pdf>, (NAKAMURA, Hideto, KACHI, Sumio, WATANABE, Daisuke, KUBOYAMA, Hirotoshi, ARIMA, Yasuhiro, MIURA, Masaru.), non-official translation (Development of battery condition monitoring device (BMU). Furukawa Electric Times.) 「3.2 BMU(蓄電池状態監視装置)」 の項, non-official translation (Section "3.2 BMU (Battery Status Monitoring Device)") | 1-8 |
| A | 中島秀仁; 本間徳則; 緑川淳; 赤阪有一; 柴田智史; 吉田英明; 橋本健介; 荻野由涼; 手塚渉; 三浦優; 古川淳; LAM, L. T.; 菅田純雄, ウルトラバッテリーの開発, 古河電工時報, February 2013, no. 131, pages 21-27, available at internet <URL:https://www.furukawa.co.jp/jiho/fj131/fj131_04.pdf>, (Development of Ultrabattery. NAKAJIMA, Hidehito, HONMA, Tokunori, MIDORIKAWA, Kiyoshi, AKASAKA, Yuichi, SHIBATA, Satoshi, YOSHIDA, Hideaki, HASHIMOTO, Kensuke, OGINO, Yusuke, TEZUKA, Wataru, MIURA, Masaru, FURUKAWA, Jun, LAM, L. T., SUGATA, Sumio.), non-official translation (Furukawa Electric Times.) 「2.2.2 試験結果」 の項, fig. 4, non-official translation (Section 2.2.2 Test Results) | 1-8 |

Form PCT/ISA/210 (second sheet) (January 2015)

## INTERNATIONAL SEARCH REPORT
### Information on patent family members

International application No.

**PCT/JP2023/002258**

| Patent document cited in search report | | | Publication date (day/month/year) | Patent family member(s) | | | Publication date (day/month/year) |
|---|---|---|---|---|---|---|---|
| JP | 2003-161768 | A | 06 June 2003 | (Family: none) | | | |
| JP | 2008-74257 | A | 03 April 2008 | (Family: none) | | | |
| JP | 6430054 | B1 | 28 November 2018 | JP | 2019-203719 | A | |
| | | | | WO | 2019/225032 | A1 | |
| WO | 2010/001605 | A1 | 07 January 2010 | US | 2011/0004428 | A1 | |
| | | | | CN | 102057289 | A | |
| WO | 2013/054672 | A1 | 18 April 2013 | US | 2014/0239900 | A1 | |
| | | | | CN | 103918120 | A | |
| WO | 2010/079745 | A1 | 15 July 2010 | US | 2011/0288691 | A1 | |
| | | | | EP | 2386754 | A1 | |
| | | | | KR | 10-2011-0033278 | A | |
| | | | | CN | 102124219 | A | |
| CN | 103529399 | A | 22 January 2014 | (Family: none) | | | |
| CN | 112290637 | A | 29 January 2021 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H2288074 A